(19) Europäisches Patentamt
European Patent Office
Office européen des brevets

(11) EP 4 317 339 A1

(12) **EUROPEAN PATENT APPLICATION**
published in accordance with Art. 153(4) EPC

(43) Date of publication:
**07.02.2024 Bulletin 2024/06**

(21) Application number: **22780283.2**

(22) Date of filing: **22.03.2022**

(51) International Patent Classification (IPC):
***C09J 5/06*** *(2006.01)* ***C09J 11/06*** *(2006.01)*
***C09J 183/04*** *(2006.01)* ***C09J 201/00*** *(2006.01)*
***H01L 21/02*** *(2006.01)*

(52) Cooperative Patent Classification (CPC):
**C09J 5/06; C09J 11/06; C09J 183/04; C09J 201/00; H01L 21/02**

(86) International application number:
**PCT/JP2022/012975**

(87) International publication number:
**WO 2022/210068 (06.10.2022 Gazette 2022/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.03.2021 JP 2021057323**

(71) Applicant: **Nissan Chemical Corporation**
**Tokyo 103-6119 (JP)**

(72) Inventors:
- **USUI Yuki**
  **Toyama-shi, Toyama 939-2792 (JP)**
- **OKUNO Takahisa**
  **Toyama-shi, Toyama 939-2792 (JP)**
- **YANAI Masaki**
  **Toyama-shi, Toyama 939-2792 (JP)**
- **SHINJO Tetsuya**
  **Toyama-shi, Toyama 939-2792 (JP)**

(74) Representative: **Hoffmann Eitle**
**Patent- und Rechtsanwälte PartmbB**
**Arabellastraße 30**
**81925 München (DE)**

# (54) ADHESIVE COMPOSITION, LAMINATE, METHOD FOR MANUFACTURING LAMINATE, AND METHOD FOR MANUFACTURING PROCESSED SUBSTRATE

(57) An adhesive composition, wherein the adhesive composition is applied to obtain an adhesive coating layer having a complex viscosity of 10 Pa·s or more and 10,000 Pa·s or less at 25°C or more and 100°C or less, and the adhesive coating layer has a viscosity reduction rate of 80% or less determined by the following formula (1):

$$\text{Viscosity reduction rate (\%)} = ((V_{25} - V_{100})/V_{25}) \times 100 \quad \cdots \text{Formula (1)}$$

wherein
$V_{25}$: Complex viscosity at 25°C, and
$V_{100}$: Complex viscosity at 100°C.

FIG. 1

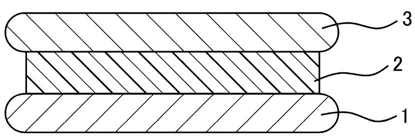


EP 4 317 339 A1

## Description

### Technical Field

The present invention relates to an adhesive composition, a laminate, a method of manufacturing a laminate, and a method of manufacturing a processed substrate.

### Background Art

When two substrates are bonded using an adhesive composition, the adhesive coating layer formed from the adhesive composition may protrude from between the two substrates. The adhesive coating layer protruding from between the two substrates contaminates the periphery.

In order to prevent a display panel adhesive from protruding from the body to be coated or the body to be bonded, it has been proposed to form a liquid stopper (dam) outside the coating region before the display panel adhesive is applied (Patent Literature 1 and 2). However, in order to prevent air from entering the display unit, it is necessary for the display panel adhesive to go over the liquid stopper, and the display panel adhesive that has gone over the liquid stopper may protrude from the body to be coated or the body to be bonded to contaminate the periphery.

As a display panel adhesive that causes no adhesive protrusion from a member to be bonded with the adhesive, there has been proposed a display panel adhesive including: (A) a polymer containing 1.5 or more polymerizable carbon-carbon double bonds on average in a molecule and having a number average molecular weight (Mn) of 5,000 or more; (B) a polymer containing one or less polymerizable carbon-carbon double bonds on average in a molecule and having a number average molecular weight (Mn) of 5,000 or more; (C) a photopolymerization initiator; and (D) a hydrophilic silica having a specific surface area of 200 $m^2/g$ or more, wherein the component (D) is 4 parts by weight or more and 20 parts by weight or less with respect to 100 parts by weight of the total of the component (A) and the component (B), and the maximum coarse particle is 30 um or less (Patent Literature 3).

### Citation List

### Patent Literature

Patent Literature 1: JP 2009-8851 A
Patent Literature 2: JP 2010-66711 A
Patent Literature 3: JP 2014-221893 A

### Summary of Invention

### Technical Problem

When two substrates are bonded to each other, it may be better to perform bonding while heating the substrates in order to ensure the bonding. However, when two substrates are bonded to each other while the substrates are heated, protrusion of the adhesive coating layer formed from the adhesive composition is more likely to occur than when the two substrates are bonded to each other at normal temperature.

By the way, when two substrates are bonded, it is necessary to form a uniform adhesive layer without voids.

The present invention has been made in view of the above circumstances, and an object thereof is to provide: an adhesive composition capable of forming a uniform adhesive layer without voids and suppressing protrusion of the adhesive coating layer from between two substrates when the two substrates are bonded to each other while being heated; a laminate using the adhesive composition; a method of manufacturing the laminate; and a method of manufacturing a processed substrate using the adhesive composition.

### Solution to Problem

As a result of intensive studies to solve the above problems, the present inventors have found that the above problems can be solved, and have completed the present invention having the following gist.

That is, the present invention includes the following.

[1] An adhesive composition,

wherein the adhesive composition is applied to obtain an adhesive coating layer having a complex viscosity of 10 Pa·s or more and 10,000 Pa·s or less at 25°C or more and 100°C or less, and the adhesive coating layer has a viscosity reduction rate of 80% or less determined by the following formula (1):

$$\text{Viscosity reduction rate (\%)} = ((V_{25} - V_{100})/V_{25}) \times 100 \cdots \text{Formula (1)}$$

wherein

$V_{25}$: Complex viscosity at 25°C,
$V_{25}$: Complex viscosity at 25°C, and
$V_{100}$: Complex viscosity at 100°C.

[2] An adhesive composition being used for a manufacturing process of a laminate, the process including: a step in which the adhesive composition is applied to form an adhesive coating layer that becomes an adhesive layer; and a step in which a first substrate and a second substrate are bonded to each other under heating and pressurization to be in contact with each other through the adhesive coating layer,
wherein the adhesive composition is applied to obtain an adhesive coating layer having a complex viscosity of 10 Pa·s or more and 10,000 Pa·s or less at 25°C or more and a temperature in the heating or less, and the adhesive coating layer has a viscosity reduction rate of 80% or less determined by the following formula (1):

$$\text{Viscosity reduction rate (\%)} = ((V_{25} - V_{T})/V_{25}) \times 100 \cdots \text{Formula (2)}$$

wherein

$V_{25}$: Complex viscosity at 25°C, and
$V_{T}$: Complex viscosity at a temperature in the heating.

[3] The adhesive composition according to [1] or [2], comprising a component (A), which is curable, as an adhesive component.
[4] The adhesive composition according to [3], wherein the component (A) is cured through hydrosilylation reaction.
[5] The adhesive composition according to [3] or [4], wherein
the component (A) includes:

a polyorganosiloxane (a1) having an alkenyl group bonded to a silicon atom and having 2 to 40 carbon atoms;
a polyorganosiloxane (a2) having a Si-H group; and
a platinum group metal-based catalyst (A2).

[6] The adhesive composition according to [5], wherein at least one selected from the polyorganosiloxane (a1) having an alkenyl group bonded to a silicon atom and having 2 to 40 carbon atoms and the polyorganosiloxane (a2) having a Si-H group has a complex viscosity of 1,000 to 10,000 Pa·s.
[7] The adhesive composition according to any one of [1] to [6], comprising a non-curable polyorganosiloxane as a component (B), which causes no curing reaction.
[8] The adhesive composition according to [7], wherein the non-curable polyorganosiloxane has a complex viscosity of 1,000 to 10,000 Pa-s.
[9] A laminate comprising: a first substrate; a second substrate; and an adhesive layer provided between the first substrate and the second substrate,
wherein the adhesive layer is formed from the adhesive composition according to any one of [1] to [8].
[10] The laminate according to [9], further comprising a release layer provided between the first substrate and the second substrate.
[11] The laminate according to [9] or [10], wherein the first substrate is a substrate having a semiconductor and the second substrate is a support substrate.
[12] A method of manufacturing a laminate, the method comprising:

a step in which the adhesive composition according to any one of [1] to [8] is applied to form an adhesive coating layer that becomes an adhesive layer; and
a step in which a first substrate and a second substrate are bonded to each other under heating and pressurization to be in contact with each other through the adhesive coating layer.

[13] The method of manufacturing a laminate according to [12], further comprising a step in which the adhesive coating layer is heated to form the adhesive layer, after the bonding step.
[14] The method of manufacturing a laminate according to [12] or [13], comprising a step in which a release agent composition is applied to form a release agent coating layer that becomes a release layer,
wherein the bonding step is a step in which a first substrate and a second substrate are bonded to each other under heating and pressurization to be in contact with each other through the release agent coating layer and the adhesive coating layer.
[15] The method of manufacturing a laminate according to any one of [12] to [14], wherein the first substrate is a substrate having a semiconductor and the second substrate is a support substrate.
[16] A method of manufacturing a processed substrate, the method comprising:

a first step in which the first substrate of the laminate according to any one of [9] to [11] is processed; and
a second step in which the first substrate processed in the first step is separated from the second substrate.

## Advantageous Effects of Invention

The present invention can provide: an adhesive composition capable of forming a uniform adhesive layer without voids and suppressing protrusion of the adhesive coating layer from between two substrates when the two substrates are bonded to each other while being heated; a laminate using the adhesive composition; a method of manufacturing the laminate; and a method of manufacturing a processed substrate using the adhesive composition.
The void means a state in which air bubbles are present between a substrate and a layer, between two layers, or in a layer of the laminate. In such a state in which undesirable air bubbles are present, there are concerns: when a load such as a pressure necessary for manufacturing is applied to the laminate, a bias is generated in the load to deteriorate total thickness variation (TTV); unevenness of wafer thickness is generated in the processing step (back grinding) of a semiconductor substrate; damage to the wafer or adhesive layer residues are generated due to the bias of a pressure applied in the release step (during debonding); and the like. Therefore, it is not possible to expect production of a good semiconductor element with good reproducibility.

## Brief Description of Drawings

Fig. 1 is a schematic cross-sectional view of an example of the laminate.
Fig. 2 is a schematic cross-sectional view of another example of the laminate.
Fig. 3 is a schematic cross-sectional view of another example of the laminate.
Fig. 4A is an overall photograph of the laminate in Example 2-1.
Fig. 4B is an enlarged photograph of the vicinity of the wafer notch of the laminate in Example 2-1.
Fig. 5A is an overall photograph of the laminate in Comparative Example 2-1.
Fig. 5B is an enlarged photograph of the vicinity of the wafer notch of the laminate in Comparative Example 2-1.

## Description of Embodiments

### (Adhesive composition)

In an embodiment on the present invention, the adhesive composition is applied to obtain an adhesive coating layer having a complex viscosity of 10 Pa·s or more and 10,000 Pa·s or less at 25°C or more and 100°C or less, and the adhesive coating layer has a viscosity reduction rate of 80% or less determined by the following formula (1)
(Hereinafter, these two conditions are sometimes referred to as "the first conditions"):

$$\text{Viscosity reduction rate (\%)} = ((V_{25} - V_{100})/V_{25}) \times 100 \cdots \text{Formula (1)}$$

wherein

$V_{25}$: Complex viscosity at 25°C, and
$V_{100}$: Complex viscosity at 100°C.

In another embodiment of the present invention, the adhesive composition is used for a manufacturing process of a laminate, the process including: a step in which the adhesive composition is applied to form an adhesive coating layer that becomes an adhesive layer; and a step in which a first substrate and a second substrate are bonded to each other under heating and pressurization to be in contact with each other through the adhesive coating layer.

The adhesive composition is applied to obtain an adhesive coating layer having a complex viscosity of 10 Pa·s or more and 10,000 Pa·s or less at 25°C or more and a temperature in the heating or less, and the adhesive coating layer has a viscosity reduction rate of 80% or less determined by the following formula (2) (Hereinafter, these two conditions are sometimes referred to as "the second conditions"):

$$\text{Viscosity reduction rate (\%)} = ((V_{25} - V_T)/V_{25}) \times 100 \cdots$$

Formula (2)

wherein

$V_{25}$: Complex viscosity at 25°C, and
$V_T$: Complex viscosity at a temperature in the heating.

The first substrate and the second substrate will be described later.

The complex viscosity in the present invention can be measured, for example, as follows.

The adhesive composition is applied onto a substrate (for example, a silicon wafer) and heated (preheat treatment: for example, at 120°C for 1.5 minutes) to form an adhesive coating layer having a thickness of about 100 μm on the substrate. The adhesive coating layer is isolated from the obtained substrate with the adhesive coating layer, and the complex viscosity is measured with a rheometer (for example, MCR-302, a rheometer manufactured by Anton Paar GmbH). The measurement is performed, for example, under the conditions of a temperature raising rate of 0.83 °C/sec, a strain of 2%, and a frequency of 1 Hz.

The present inventors have conducted intensive studies in order to form a uniform adhesive layer without voids and suppress protrusion of the adhesive coating layer from between two substrates when the two substrates are bonded to each other while being heated.

As a result, it has been found the following: the adhesive coating layer, having a complex viscosity satisfying the first conditions or the second conditions, makes it possible to form a uniform adhesive layer without voids and suppress protrusion of the adhesive coating layer from between two substrates when the two substrates are bonded to each other while being heated.

When the complex viscosity of the adhesive coating layer at the time of bonding is too low, the adhesive coating layer tends to protrude from between the two substrates. On the other hand, when the complex viscosity of the adhesive coating layer is too high, a uniform adhesive coating layer is not formed when the adhesive composition is applied. As a result, voids are generated, which makes it difficult to form a uniform adhesive layer.

In addition, with a smaller change rate in the complex viscosity of the adhesive coating layer at a temperature of 25°C or higher and a specific temperature or lower, it is possible to widen the range of heating conditions and pressurization conditions for achieving both formation of a uniform adhesive layer without voids and suppression of protrusion of the adhesive coating layer from between the two substrates.

The complex viscosity of the adhesive coating layer gradually decreases, for example, from 25°C to 100°C or from 25°C to a temperature of the heating.

The method for making the complex viscosity of the adhesive coating layer satisfy the first conditions or the second conditions is not particularly limited. Examples thereof include a method in which a high-viscosity material is contained in the adhesive composition in a relatively high blending amount. Examples of the high-viscosity material include materials having a complex viscosity of 1,000 Pa·s or more at 25°C. For example, a material having a complex viscosity of 1,000 Pa·s or more and 10,000 Pa·s or less at 25°C is contained in an amount of about 20 to 80 parts by mass in 100 parts by mass of the film constituent components, thereby the complex viscosity of the adhesive composition easily satisfies the first conditions or the second conditions. In the present invention, the term "film constituent components" means components other than a solvent contained in the composition.

In the first conditions, the complex viscosity of the adhesive coating layer is 10 Pa·s or more and 10,000 Pa·s

or less at 25°C or more and 100°C or less. From the viewpoint of reproducibly realizing the effect of the present invention, the complex viscosity is preferably 100 Pa·s or more and 10,000 Pa·s or less, and more preferably 500 Pa·s or more and 5,000 Pa·s or less.

In the second conditions, the complex viscosity of the adhesive coating layer is 10 Pa·s or more and 10,000 Pa·s or less at 25°C or more and a temperature in the heating or less. From the viewpoint of reproducibly realizing the effect of the present invention, the complex viscosity is preferably 100 Pa·s or more and 10,000 Pa·s or less, and more preferably 500 Pa·s or more and 5,000 Pa·s or less.

In the first conditions, the viscosity reduction rate of the adhesive coating layer as determined by the formula (1) is 80% or less. From the viewpoint of reproducibly realizing the effect of the present invention, the viscosity reduction rate is preferably 10% or more and 80% or less, and more preferably 150 or more and 65% or less.

In the second conditions, the viscosity reduction rate of the adhesive coating layer as determined by the formula (2) is 80% or less. From the viewpoint of reproducibly realizing the effect of the present invention, the viscosity reduction rate is preferably 10% or more and 80% or less, and more preferably 150 or more and 65% or less.

Examples of the adhesive composition include, but are not limited to, a polysiloxane-based adhesive, an acrylic resin-based adhesive, an epoxy resin-based adhesive, a polyamide-based adhesive, a polystyrene-based adhesive, a polyimide adhesive, and a phenol resin-based adhesive.

Among them, a polysiloxane-based adhesive is preferable as the adhesive composition because of: suitable adhesive ability exhibited during processing of a semiconductor substrate or the like, which is an example of the first substrate; being able to suitably release after processing; and further, excellent heat resistance.

The adhesive composition may be a thermosetting adhesive composition or a thermoplastic adhesive composition, and a thermosetting adhesive composition is preferable.

In a preferred embodiment, the thermosetting adhesive composition contains a component that cures by hydrosilylation reaction.

More specific embodiments of the thermosetting adhesive composition used in the present invention may include, for example, the following <<First Embodiment>> to <<Third Embodiment>>.

More specific embodiments of the thermoplastic adhesive composition used in the present invention may include, for example, <<Fourth Embodiment>>.

<<First Embodiment>>

For example, the adhesive composition of the present invention contains a component (A), which is curable, as an adhesive component. The adhesive composition of the present invention may contain the component (A), which is curable, as an adhesive component, and a component (B), which causes no curing reaction. Here, examples of the component (B), which causes no curing reaction, include polyorganosiloxanes. In the present invention, the term "causes no curing reaction" does not mean not causing any curing reactions, but means not causing a curing reaction occurring in the component (A), which is curable.

In another preferred embodiment, the component (A) may be a component that is cured by hydrosilylation reaction, or may be a polyorganosiloxane component (A') that is cured by hydrosilylation reaction.

In another preferred embodiment, the component (A) includes, for example: a polyorganosiloxane (a1) having an alkenyl group bonded to a silicon atom and having 2 to 40 carbon atoms; a polyorganosiloxane (a2) having a Si-H group; and a platinum group metal-based catalyst (A2), as an example of the component (A'). Here, the alkenyl group having 2 to 40 carbon atoms may be substituted. Examples of the substituent include a halogen atom, a nitro group, a cyano group, an amino group, a hydroxy group, a carboxyl group, an aryl group, and a heteroaryl group.

In another preferred embodiment, the polyorganosiloxane component (A') that is cured by hydrosilylation reaction includes a polysiloxane (A1) containing one or two or more units selected from the group consisting of a siloxane unit (Q unit) represented by $SiO_2$, a siloxane unit (M unit) represented by $R^1R^2R^3SiO_{1/2}$, a siloxane unit (D unit) represented by $R^4R^5SiO_{2/2}$, and a siloxane unit (T unit) represented by $R^6SiO_{3/2}$, and a platinum group metal-based catalyst (A2). The polysiloxane (A1) includes: a polyorganosiloxane (a1') containing one or two or more units selected from the group consisting of a siloxane unit (Q' unit) represented by $SiO_2$, a siloxane unit (M' unit) represented by $R^{1'}R^{2'}R^{3'}SiO_{1/2}$, a siloxane unit (D' unit) represented by $R^{4'}R^{5'}SiO_{2/2}$, and a siloxane unit (T' unit) represented by $R^{6'}SiO_{3/2}$, and also containing at least one selected from the group consisting of the M' unit, the D' unit, and the T' unit; and a polyorganosiloxane (a2') containing one or two or more units selected from the group consisting of a siloxane unit (Q" unit) represented by $SiO_2$, a siloxane unit (M" unit) represented by $R^{1''}R^{2''}R^{3''}SiO_{1/2}$, a siloxane unit (D" unit) represented by $R^{4''}R^{5''}SiO_{2/2}$, and a siloxane unit (T" unit) represented by $R^{6''}SiO_{3/2}$, and also containing at least one selected from the group consisting of the M" unit, the D" unit, and the T" unit.

Note that (a1') is an example of (a1), and (a2') is an example of (a2).

$R^1$ to $R^6$ are groups or atoms bonded to a silicon atom, and each independently represent an optionally substituted alkyl group, an optionally substituted alkenyl group, or a hydrogen atom. Examples of the substituent include a

halogen atom, a nitro group, a cyano group, an amino group, a hydroxy group, a carboxyl group, an aryl group, and a heteroaryl group.

$R^{1'}$ to $R^{6'}$ are groups bonded to a silicon atom and each independently represent an optionally substituted alkyl group or an optionally substituted alkenyl group, and at least one of $R^{1'}$ to $R^{6'}$ is an optionally substituted alkenyl group. Examples of the substituent include a halogen atom, a nitro group, a cyano group, an amino group, a hydroxy group, a carboxyl group, an aryl group, and a heteroaryl group.

$R^{1''}$ to $R^{6''}$ are groups or atoms bonded to a silicon atom and each independently represent an optionally substituted alkyl group or a hydrogen atom, and at least one of $R^{1''}$ to $R^{6''}$ is a hydrogen atom. Examples of the substituent include a halogen atom, a nitro group, a cyano group, an amino group, a hydroxy group, a carboxyl group, an aryl group, and a heteroaryl group.

The alkyl group may be linear, branched, or cyclic, and is preferably a linear or branched alkyl group. The number of carbon atoms thereof is not particularly limited, and is usually 1 to 40, preferably 30 or less, more preferably 20 or less, and still more preferably 10 or less.

Specific examples of the linear or branched alkyl group which may be substituted include a methyl group, an ethyl group, a n-propyl group, an i-propyl group, a n-butyl group, an i-butyl group, a s-butyl group, a tertiary butyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, but are not limited thereto. The number of carbon atoms thereof is usually 1 to 14, preferably 1 to 10, and more preferably 1 to 6. Among them, a methyl group is particularly preferable.

Specific examples of the cyclic alkyl group which may be substituted include: cycloalkyl groups, such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group; and bicycloalkyl groups, such as a bicyclobutyl group, a bicyclopentyl group, a bicyclohexyl group, a bicycloheptyl group, a bicyclooctyl group, a bicyclononyl group, and a bicyclodecyl group, but are not limited thereto. The number of carbon atoms thereof is usually 3 to 14, preferably 4 to 10, and more preferably 5 to 6.

The alkenyl group may be linear or branched, and the number of carbon atoms thereof is not particularly limited, and is usually 2 to 40, and is preferably 30 or less, more preferably 20 or less, and still more preferably 10 or less.

Specific examples of the linear or branched alkenyl group which may be substituted include a vinyl group, an allyl group, a butenyl group, and a pentenyl group, and are not limited thereto. The number of carbon atoms thereof is usually 2 to 14, preferably 2 to 10, and more preferably 1 to 6. Among them, an ethenyl group and a 2-propenyl group are particularly preferable.

Specific examples of the cyclic alkenyl group which may be substituted include, but are not limited to, cyclopentenyl and cyclohexenyl. The number of carbon atoms thereof is usually 4 to 14, preferably 5 to 10, and more preferably 5 to 6.

As described above, the polysiloxane (A1) contains the polyorganosiloxane (a1') and the polyorganosiloxane (a2'), and an alkenyl group contained in the polyorganosiloxane (a1') and a hydrogen atom (Si-H group) contained in the polyorganosiloxane (a2') form a crosslinked structure through hydrosilylation reaction by the platinum group metal-based catalyst (A2) to be cured. As a result, a cured film is formed.

The polyorganosiloxane (a1') contains one or two or more units selected from the group consisting of the Q' unit, the M' unit, the D' unit, and the T' unit, and also contains at least one selected from the group consisting of the M' unit, the D' unit, and the T' unit. As the polyorganosiloxane (a1'), two or more kinds of polyorganosiloxane satisfying such conditions may be used in combination.

Preferred combinations of two or more selected from the group consisting of the Q' unit, the M' unit, the D' unit, and the T' unit include, but are not limited to, (the Q' unit and the M' unit), (the D' unit and the M' unit), (the T' unit and the M' unit), and (the Q' unit, the T' unit, and the M' unit).

When the polyorganosiloxane (a1') contains two or more kinds of polyorganosiloxane, a combination of (the

Q' unit and the M' unit) and (the D' unit and the M' unit), a combination of (the T' unit and the M' unit) and (the D' unit and the M' unit), and a combination of (the Q' unit, the T' unit, and the M' unit) and (the T' unit and the M' unit) are preferable, but the combination is not limited thereto.

The polyorganosiloxane (a2') contains one or two or more units selected from the group consisting of the Q" unit, the M" unit, the D" unit, and the T" unit, and also contains at least one selected from the group consisting of the M" unit, the D" unit, and the T" unit. As the polyorganosiloxane (a2'), two or more kinds of polyorganosiloxane satisfying such conditions may be used in combination.

Preferred combinations of two or more selected from the group consisting of the Q" unit, the M" unit, the D" unit, and the T" unit include, but are not limited to, (the M" unit and the D" unit), (the Q" unit and the M" unit), and (the Q" unit, the T" unit, and the M'' unit).

The polyorganosiloxane (a1') is composed of siloxane units in which alkyl groups and/or alkenyl groups are bonded to silicon atoms thereof, and the proportion of alkenyl groups in the total substituents represented by $R^{1'}$ to $R^{6'}$ is preferably 0.1 to 50.0 mol% and more preferably 0.5 to 30.0 mol%, and the remaining $R^{1'}$ to $R^{6'}$ may be alkyl groups.

The polyorganosiloxane (a2') is composed of siloxane units in which alkyl groups and/or hydrogen atoms are bonded to silicon atoms thereof, and the ratio of hydrogen atoms in the total substituent groups and substituent atoms represented by $R^{1''}$ to $R^{6''}$ is preferably 0.1 to 50.0 mol% and more preferably 10.0 to 40.0 mol%, and the remaining $R^{1''}$ to $R^{6''}$ may be alkyl groups.

When the component (A) contains (a1) and (a2), in a preferred embodiment of the present invention, the molar ratio of the alkenyl group contained in the polyorganosiloxane (a1) and the hydrogen atom constituting the Si-H bond contained in the polyorganosiloxane (a2) is in a range of 1.0 : 0.5 to 1.0 : 0.66.

The weight average molecular weight of the polysiloxanes such as the polyorganosiloxane (a1) and the polyorganosiloxane (a2) is not particularly limited, and is usually 100 to 1,000,000, and is preferably 5,000 to 800,000 from the viewpoint of reproducibly realizing the effects of the present invention.

In the present invention, the weight average molecular weight, the number average molecular weight, and the dispersibility of the polyorganosiloxanes can be measured, for example, using a GPC apparatus (HLC-8320GPC; manufactured by Tosoh Corporation) and a GPC column (TSKgel SuperMultipore HZ-N and TSKgel SuperMultipore HZ-H; manufactured by Tosoh Corporation), at a column temperature of 40°C, using tetrahydrofuran as an eluent (eluent solvent), at a flow amount (flow rate) of 0.35 mL/min, and using polystyrene (Shodex from Showa Denko K.K.) as a standard sample.

The viscosity of the polyorganosiloxane (a1) and the polyorganosiloxane (a2) are not particularly limited, and are each usually in a range of 10 to 1000000 (mPa-s). The viscosity (mPa.s) of the polyorganosiloxane (a1) and the polyorganosiloxane (a2) are values measured with an E-type rotational viscometer at 25°C.

However, the viscosity of the polyorganosiloxane (a1) and the polyorganosiloxane (a2) are not necessarily included in this range. Among polyorganosiloxanes having a complex viscosity value within the predetermined range of the present invention, there are polyorganosiloxanes having a viscosity outside this range and polyorganosiloxanes whose viscosity cannot be measured with an E-type rotational viscometer.

The polyorganosiloxane (a1) and the polyorganosiloxane (a2) react with each other through hydrosilylation reaction to form a film. Therefore, the curing mechanism is different from that via, for example, silanol groups. Therefore, any siloxane does not need to contain a silanol group or a functional group that forms a silanol group through hydrolysis, such as an alkyloxy group.

In a preferred embodiment of the present invention, the adhesive composition contains a platinum group metal-based catalyst (A2) together with the polyorganosiloxane component (A').

Such a platinum-based metal catalyst is a catalyst for promoting hydrosilylation reaction between the alkenyl group of the polyorganosiloxane (a1) and the Si-H group of the polyorganosiloxane (a2).

Specific examples of the platinum-based metal catalyst include platinum-based catalysts such as platinum black, platinum (II) chloride, chloroplatinic acid, a reaction product of chloroplatinic acid and a monohydric alcohol, a complex of chloroplatinic acid and olefins, and platinum bisacetoacetate, but are not limited thereto.

Examples of the complex of platinum and olefins include, but are not limited to, a complex of divinyltetramethyldisiloxane and platinum.

The amount of the platinum group metal-based catalyst (A2) is not particularly limited, but is usually in a range of 1.0 to 50.0 ppm with respect to the total amount of the polyorganosiloxane (a1) and the polyorganosiloxane (a2).

The polyorganosiloxane component (A') may contain a polymerization inhibitor (A3) for the purpose of suppressing the progress of hydrosilylation reaction.

The polymerization inhibitor is not particularly limited as long as it can suppress the progress of hydrosilylation reaction, and specific examples thereof include alkynyl alcohols such as 1-ethynyl-1-cyclohexanol and 1,1-diphenyl-2-propion-1-ol.

The amount of the polymerization inhibitor is not particularly limited, and is usually 1000.0 ppm or more with respect to the total amount of the polyorganosiloxane (a1) and the polyorganosiloxane (a2) from the viewpoint of obtaining

the effect, and is 10000.0 ppm or less from the viewpoint of preventing excessive suppression of hydrosilylation reaction.

The adhesive composition of the present invention, as an example, may contain a component (B), which causes no curing reaction, together with the component (A). By including such a component (B) in the adhesive composition, the adhesive composition satisfying the first conditions or the second conditions is easily obtained.

Typical examples of the component (B) include non-curable polyorganosiloxanes, and specific examples thereof include epoxy group-containing polyorganosiloxanes, methyl group-containing polyorganosiloxanes, and phenyl group-containing polyorganosiloxanes, but are not limited thereto.

Examples of the component (B) include non-curable polydimethylsiloxane. The polydimethylsiloxane may be modified. Examples of the polydimethylsiloxane which may be modified include, but are not limited to, an epoxy group-containing polydimethylsiloxane, an unmodified polydimethylsiloxane, and a phenyl group-containing polydimethylsiloxane.

Preferred examples of the non-curable polyorganosiloxane as the component (B) include epoxy group-containing polyorganosiloxanes, methyl group-containing polyorganosiloxanes, and phenyl group-containing polyorganosiloxanes, but are not limited thereto.

The weight average molecular weight of the non-curable polyorganosiloxane as the component (B) is not particularly limited, and is usually 100,000 to 2,000,000, and is preferably 150,000 to 1,200,000, more preferably 200,000 to 800,000 from the viewpoint of reproducibly realizing the effects of the present invention. The dispersion degree is not particularly limited, and is usually 1.0 to 10.0, preferably 1.5 to 5.0, and more preferably 2.0 to 3.0.

The viscosity of the non-curable polyorganosiloxane is not particularly limited, and is usually in a range of 10 to 1000000 (mPa·s). The viscosity (mPa·s) of the non-curable polyorganosiloxane is a value measured with an E-type rotational viscometer at 25°C.

However, the viscosity of the non-curable polyorganosiloxane is not necessarily included in the range. Among polyorganosiloxanes having a complex viscosity value in the predetermined range of the present invention, there are polyorganosiloxanes having a viscosity outside the range or polyorganosiloxanes whose viscosity cannot be measured with an E-type rotational viscometer.

Examples of the epoxy group-containing polyorganosiloxane include those containing a siloxane unit ($D^{10}$ unit) represented by $R^{11}R^{12}SiO_{2/2}$.

$R^{11}$ is a group bonded to a silicon atom and represents an alkyl group. $R^{12}$ is a group bonded to a silicon atom and represents an epoxy group or an organic group containing an epoxy group. Specific examples of the alkyl group can include the above-described examples.

The epoxy group in the organic group containing an epoxy group may be an independent epoxy group that is not fused with other rings, or may be an epoxy group forming a fused ring with other rings, such as a 1,2-epoxycyclohexyl group.

Specific examples of the organic group containing an epoxy group include, but are not limited to, 3-glycidoxypropyl and 2-(3,4-epoxycyclohexyl) ethyl.

In the present invention, preferred examples of the epoxy group-containing polyorganosiloxane include, but are not limited to, an epoxy group-containing polydimethylsiloxane.

The epoxy group-containing polyorganosiloxane contains the above-described siloxane unit ($D^{10}$ unit), and may contain the Q unit, the M unit, and/or the T unit in addition to the $D^{10}$ unit.

In a preferred embodiment of the present invention, specific examples of the epoxy group-containing polyorganosiloxane include a polyorganosiloxane composed only of the $D^{10}$ unit, a polyorganosiloxane containing the $D^{10}$ unit and the Q unit, a polyorganosiloxane containing the $D^{10}$ unit and the M unit, a polyorganosiloxane containing the $D^{10}$ unit and the T unit, a polyorganosiloxane containing the $D^{10}$ unit, the Q unit, and the M unit, a polyorganosiloxane containing the $D^{10}$ unit, the M unit, and the T unit, and a polyorganosiloxane containing the $D^{10}$ unit, the Q unit, the M unit, and the T unit.

The epoxy group-containing polyorganosiloxane is preferably an epoxy group-containing polydimethylsiloxane having an epoxy value of 0.1 to 5. The weight average molecular weight thereof is not particularly limited, and is usually 1,500 to 500,000, and is preferably 100,000 or less from the viewpoint of suppressing precipitation in the composition.

Specific examples of the epoxy group-containing polyorganosiloxane include, but are not limited to, those represented by the formulae (E1) to (E3).

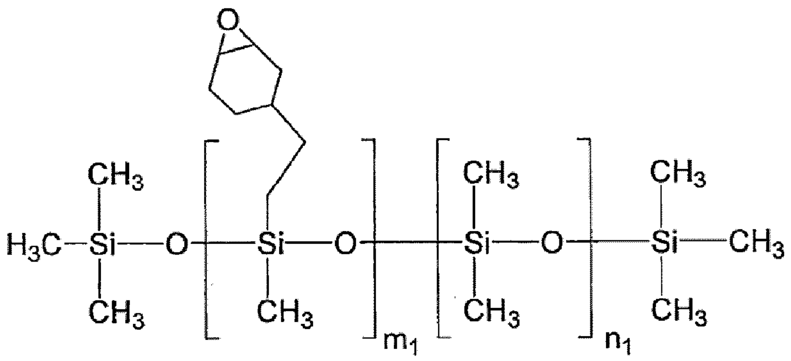

(E1)

($m_1$ and $n_1$ represent the number of each repeating unit, and are positive integers.)

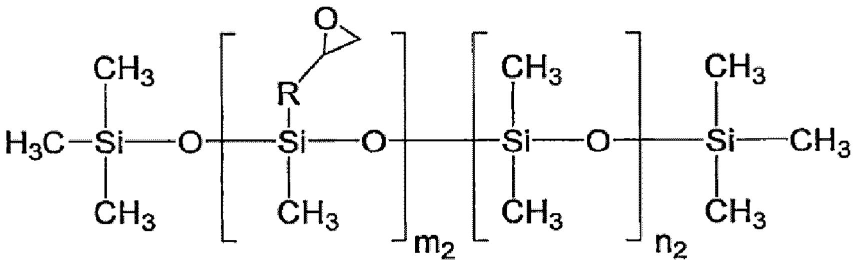

(E2)

($m_2$ and $n_2$ represent the number of each repeating unit and are positive integers, and R is an alkylene group having 1 to 10 carbon atoms.)

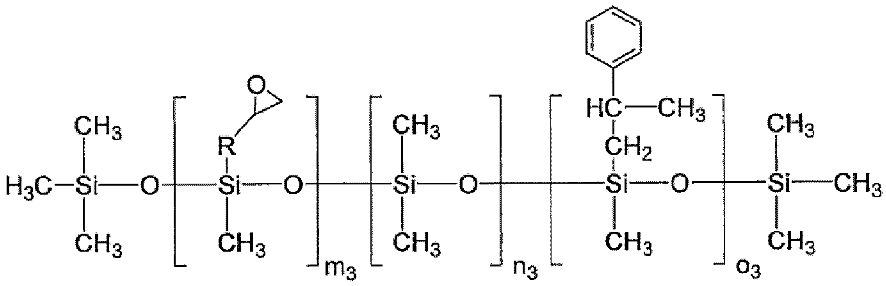

(E3)

($m_3$, $n_3$, and $o_3$ represent the number of each repeating unit, and are positive integers, and R is an alkylene group having 1 to 10 carbon atoms.)

Examples of the methyl group-containing polyorganosiloxane include those containing a siloxane unit ($D^{200}$ unit) represented by $R^{210}R^{220}SiO_{2/2}$, and preferably those containing a siloxane unit ($D^{20}$ unit) represented by $R^{21}R^{21}SiO_{2/2}$.

$R^{210}$ and $R^{220}$ are groups bonded to a silicon atom, and each independently represent an alkyl group, and at least one thereof is a methyl group, and specific examples of the alkyl group can include the above-described examples.

$R^{21}$ is a group bonded to a silicon atom and represents an alkyl group, and specific examples of the alkyl group can include the above examples. Among them, $R^{21}$ is preferably a methyl group.

In the present invention, preferred examples of the methyl group-containing polyorganosiloxane include, but are not limited to, polydimethylsiloxane.

The methyl group-containing polyorganosiloxane contains the above-described siloxane units (the $D^{200}$ unit or the $D^{20}$ unit), and may contain the Q unit, the M unit, and/or the T unit in addition to the $D^{200}$ unit and the $D^{20}$ unit.

In an embodiment of the present invention, specific examples of the methyl group-containing polyorganosiloxane include a polyorganosiloxane composed only of the $D^{200}$ unit, a polyorganosiloxane containing the $D^{200}$ unit and the Q unit, a polyorganosiloxane containing the $D^{200}$ unit and the M unit, a polyorganosiloxane containing the $D^{200}$ unit and the T unit, a polyorganosiloxane containing the $D^{200}$ unit, the Q unit, and the M unit, a polyorganosiloxane containing the $D^{200}$ unit, the M unit, and the T unit, and a polyorganosiloxane containing the $D^{200}$ unit, the Q unit, the M unit, and the T unit.

In a preferred embodiment of the present invention, specific examples of the methyl group-containing polyorganosiloxane include a polyorganosiloxane composed only of the $D^{20}$ unit, a polyorganosiloxane containing the $D^{20}$ unit and the Q unit, a polyorganosiloxane containing the $D^{20}$ unit and the M unit, a polyorganosiloxane containing the $D^{20}$ unit and the T unit, a polyorganosiloxane containing the $D^{20}$ unit, the Q unit, and the M unit, a polyorganosiloxane containing the $D^{20}$ unit, the M unit, and the T unit, and a polyorganosiloxane containing the $D^{20}$ unit, the Q unit, the M unit, and the T unit.

Specific examples of the methyl group-containing polyorganosiloxane include, but are not limited to, those represented by the formula (M1).

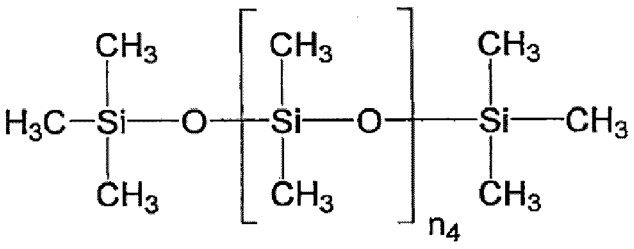 (M1)

($n_4$ represents the number of repeating units, and is a positive integer.)

Examples of the phenyl group-containing polyorganosiloxane include those containing a siloxane unit ($D^{30}$ unit) represented by $R^{31}R^{32}SiO_{2/2}$.

$R^{31}$ is a group bonded to a silicon atom and represents a phenyl group or an alkyl group. $R^{32}$ is a group bonded to a silicon atom and represents a phenyl group. Specific examples of the alkyl group include the above-described examples, and a methyl group is preferable.

The phenyl group-containing polyorganosiloxane contains the above-described siloxane unit ($D^{30}$ unit), and may contain the Q unit, the M unit, and/or the T unit in addition to the $D^{30}$ unit.

In a preferred embodiment of the present invention, specific examples of the phenyl group-containing polyorganosiloxane include a polyorganosiloxane composed only of the $D^{30}$ unit, a polyorganosiloxane containing the $D^{30}$ unit and the Q unit, a polyorganosiloxane containing the $D^{30}$ unit and the M unit, a polyorganosiloxane containing the $D^{30}$ unit and the T unit, a polyorganosiloxane containing the $D^{30}$ unit, the Q unit, and the M unit, a polyorganosiloxane containing the $D^{30}$ unit, the M unit, and the T unit, and a polyorganosiloxane containing the $D^{30}$ unit, the Q unit, the M unit, and the T unit.

Specific examples of the phenyl group-containing polyorganosiloxane include, but are not limited to, those represented by the formula (P1) or (P2).

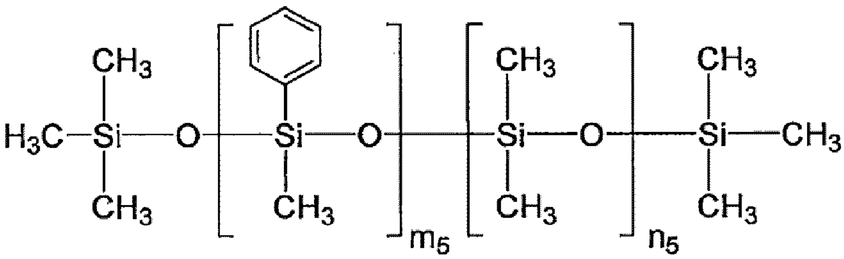 (P1)

($m_5$ and $n_5$ represent the number of each repeating unit, and are positive integers.)

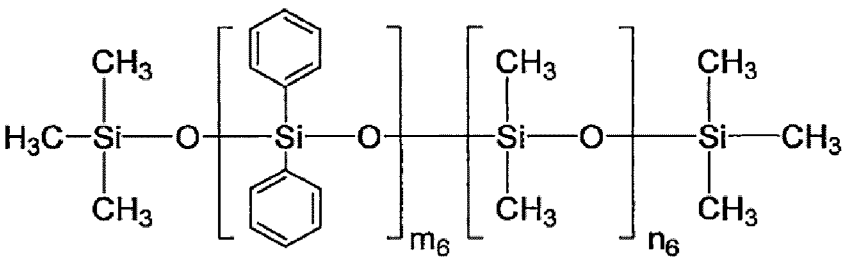 (P2)

($m_6$ and $n_6$ represent the number of each repeating unit, and are positive integers.)

In one embodiment, the adhesive composition of the present invention contains a component (B), which causes no curing reaction, together with the component (A). In a more preferred embodiment, a polyorganosiloxane is contained as the component (B).

The adhesive composition of the present invention, as an example, can contain the component (A) and the component (B) in any ratio. From the viewpoint that the complex viscosity of the adhesive coating layer can be easily adjusted within a desired range, the ratio of the component (A) to the component (B) is, in terms of mass ratio [(A) : (B)], preferably 90 : 10 to 10 : 90, and more preferably 80 : 20 to 20 : 80.

That is, when the polyorganosiloxane component (A'), which is cured through hydrosilylation reaction, is contained, the ratio of the component (A') to the component (B) is, in terms of mass ratio [(A') : (B)], preferably 90 : 10 to 10 : 90, and more preferably 80 : 20 to 20 : 80.

In the present invention, in order to satisfy the first conditions or the second conditions, it is preferable to use, for example, a high-viscosity polyorganosiloxane having a complex viscosity of about 1,000 to 10,000 Pa·s. The polyorganosiloxane may be a component in the component (A) or a component in the component (B).

That is, for example, the high-viscosity polyorganosiloxane having a complex viscosity of about 1,000 to 10,000 Pa·s may be the polyorganosiloxane (a1) having an alkenyl group bonded to a silicon atom and having 2 to 40 carbon atoms or the polyorganosiloxane (a2) having a Si-H group in the component (A), or may be the epoxy group-containing polyorganosiloxane, the methyl group-containing polyorganosiloxane, or the phenyl group-containing polyorganosiloxane in the component (B).

The high-viscosity polyorganosiloxane having a complex viscosity of about 1,000 to 10,000 Pa·s may be used singly or in combination of two or more kinds thereof.

<<Second Embodiment>>

As a preferred embodiment, the adhesive composition of the present invention contains, for example, a curable adhesive material described below, or the curable adhesive material and a release additive.

The curable adhesive material is selected from, for example, polyarylene oligomers, cyclic olefin oligomers, aryl cyclobutene oligomers, vinyl aromatic oligomers, and mixtures thereof.

Examples of the release additive include a polyether compound.

The polyether compound preferably contains a terminal group selected from the group consisting of hydroxy, alkoxy, aryloxy, and mixtures thereof.

The polyether compound is preferably selected from polyethylene glycol, polypropylene glycol, poly(1,3-propanediol), polybutylene glycol, poly(tetrahydrofuran), ethylene glycol-propylene glycol copolymers, and mixtures thereof.

The release additive is preferably selected from the group consisting of polyalkylene oxide homopolymers and polyalkylene oxide copolymers.

As the adhesive composition of the second embodiment, for example, the temporary bonding composition described in JP 2014-150239 A can be used.

The adhesive composition of the second embodiment will be described in more detail below.

The adhesive composition of the present invention contains a curable adhesive material and a release additive, and optionally an organic solvent. Typically, the curable adhesive material has a modulus of > 1 GPa when cured. Exemplary curable adhesive materials include, but are not limited to, polyarylene oligomers, cyclic olefin oligomers, aryl cyclobutene oligomers, vinyl aromatic oligomers, and mixtures thereof. The curable adhesive material may be substituted with some suitable moiety to provide additional hydrophobicity, such as a fluorine-containing group, but only if such a moiety does not adversely affect the mechanical properties of the cured adhesive material. Preferably, the curable adhesive material is selected from polyarylene oligomers, cyclic olefin oligomers, aryl cyclobutene oligomers, vinyl aromatic oligomers, and mixtures thereof, more preferably from one or more of aryl cyclobutene oligomers, vinyl aromatic oligomers, and mixtures thereof. When a mixture of different curable adhesive materials is used in the present invention, such materials are selected to cure each other during the curing process. When a mixture of different curable materials is used, these curable materials are used in a mass ratio of 99 : 1 to 1 : 99, preferably 95 : 5 to 5 : 95, more preferably 90 : 10 to 10 : 90, even more preferably 75 : 25 to 25 : 75.

A wide variety of polyarylene oligomers may be used in the present invention. As used herein, the term "polyarylene" includes polyarylene ethers. Suitable polyarylene oligomers may be synthesized from precursors such as an ethynyl aromatic compound of the following formula:

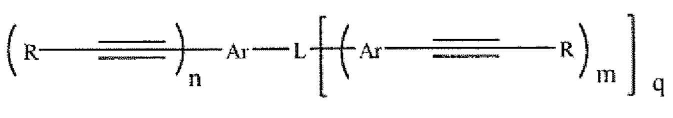

(I)

wherein each Ar is an aromatic group or an inertly substituted aromatic group; each R is independently hydrogen, alkyl, aryl, or an inertly substituted alkyl or aryl group; L is a covalent bond or a group linking one Ar to at least one other Ar; n and m are integers of at least 2; and q is an integer of at least 1. As such, the ethynyl aromatic compound usually has four or more ethynyl groups (for example, a tetraethynyl aromatic compound).

Suitable polyarylene oligomers for use in the temporary bonding composition as the adhesive composition of the second embodiment may contain a polymer having the following as a polymerization unit:

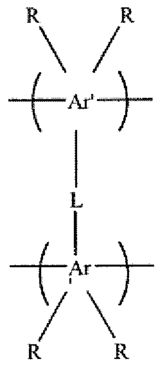

(II)

wherein Ar' is a residue of the (C = C)n-Ar or Ar-(C = C)m moiety of the reaction product, and R, L, n, and m are as defined above. Polyarylene copolymers useful in the present invention include monomers having the following formula as polymerization units:

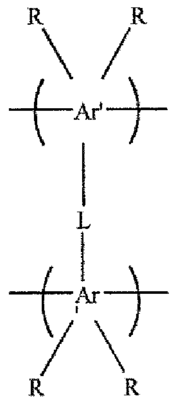

and

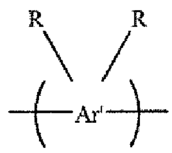

(III)

wherein Ar' and R are as defined above.

Exemplary polyarylenes include ones whose Ar-L-Ar is: biphenyl; 2,2-diphenylpropane; 9,9'-diphenylfluorene; 2,2-diphenylhexafluoropropane; diphenyl sulfide; oxydiphenylene; diphenyl ether; bis(phenylene)diphenylsilane; bis(phenylene)phosphine oxide; bis(phenylene)benzene; bis(phenylene)naphthalene; bis(phenylene)anthracene; thiodiphenylene; 1,1,1-triphenylene ethane; 1,3,5-triphenylenebenzene; 1,3,5-(2-phenylene-2-propyl)benzene; 1,1,1-triphenylene methane; 1,1,2,2-tetraphenylene-1,2-diphenylethane; bis(1,1-diphenyleneethyl)benzene; 2,2'-diphenylene-1,1,1,3,3,3-hexafluoropropane; 1,1-diphenylene-1-phenylethane; naphthalene; anthracene; or bis(phenylene)naphthacene; more preferably, biphenylene; naphthylene; p,p'-(2,2-diphenylenepropane) (or $C_6H_4$-$C(CH_3)_2$-$C_6H_4$-) ; p,p'-(2,2-diphenylene-1,1,1,3,3,3 hexafluoropropene), and (-$C_6H_4$-$C(CF_3)_2$-$C_6H_4$-), but are not limited thereto. Useful bisphenyl derivatives include 2,2-diphenylpropane; 9,9'-diphenylfluorene; 2,2-diphenylhexafluoropropane; diphenyl sulfide; diphenyl ether; bis(phenylene)diphenylsilane; bis(phenylene)phosphine oxide; bis(phenylene)benzene; bis(phenylene)naphthalene; bis(phenylene)anthracene; and bis(phenylene)naphthacene.

The polyarylene precursor monomer may be prepared by various methods known in the art, for example: (a) selectively halogenating, preferably brominating, a polyphenol (preferably a bisphenol) in a solvent (wherein each phenolic ring is halogenated with one halogen at one of the two positions that are ortho to the phenolic hydroxyl group); (b) converting the phenolic hydroxyl on the resulting poly(ortho-halophenol) to a leaving group, such as a sulfonate ester, which is reactive with and substituted by a terminal ethynyl compound, preferably in a solvent (for example, trifluoromethanesulfonate ester prepared from trifluoromethanesulfonyl halide or trifluoromethanesulfonic anhydride); and (c) reacting the reaction product of the step (b) with an ethynyl-containing compound or ethynyl synthone, in the presence

of an arylethynylation catalyst, preferably a palladium catalyst, and an acid acceptor, to simultaneously replace the halogen and the trifluoromethyl sulfonate with an ethynyl-containing group (for example, acetylene, phenylacetylene, a substituted phenylacetylene, or a substituted acetylene). The further description of this synthesis is provided in WO 97/10193 (Babb).

The ethynyl aromatic monomer of the formula (I) is useful for preparing the polymer of either the formula (II) or (III). Polymerization of the ethynyl aromatic monomer is well within the capabilities of those skilled in the art. While the specific conditions of the polymerization will depend on a variety of factors, including the specific ethynyl aromatic monomer (s) to be polymerized and the desired properties of the resulting polymer, the general conditions of the polymerization are detailed in WO 97/10193 (Babb).

Polyarylenes particularly suitable for use in the present invention include those sold as SiLK (TM) semiconductor dielectrics (available from DOW ELECTRONIC MATERIALS, based in Marlborough, MA). Other particularly suitable polyarylenes are disclosed in WO 00/31183, WO 98/11149, WO 97/10193, WO 91/09081, EP 755957, and US Pat. No. 5,115,082; No. 5,155,175; No. 5,179,188; No. 5,874,516; and No. 6,093,636.

A suitable cyclic olefin material is a poly (cyclic olefin), which may be thermoplastic and may have a weight average molecular weight (Mw) of preferably 2000 to 200,000 Daltons, more preferably 5000 to 100,000 Daltons, and even more preferably 2000 to 50,000 Daltons. Preferred poly(cyclic olefin)s have a softening temperature (melt viscosity at 3,000 PaS) of at least 100°C, more preferably at least 140°C. Suitable poly(cyclic olefin)s also preferably have a glass transition temperature (Tg) of at least 60°C, more preferably 60 to 200°C, and most preferably 75 to 160°C.

Preferred poly(cyclic olefin)s have repeating monomers of a cyclic olefin and an acyclic olefin, or a ring-opened polymer based on cyclic olefins. Suitable cyclic olefins for use in the present invention are selected from norbornene-based olefins, tetracyclododecene-based olefins, dicyclopentadiene-based olefins, Diels-Alder polymers such as those derived from furan and maleimide, and derivatives thereof. Examples of the derivative include derivatives substituted with alkyl (preferably $C_1$-$C_{20}$ alkyl, more preferably $C_1$-$C_{10}$ alkyl), alkylidene (preferably $C_1$-$C_{20}$ alkylidene, more preferably $C_1$-$C_{10}$ alkylidene), aralkyl (preferably $C_6$-$C_{30}$ aralkyl, more preferably $C_6$-$C_{18}$ aralkyl), cycloalkyl (preferably $C_3$-$C_{30}$ cycloalkyl, more preferably $C_3$-$C_{18}$ cycloalkyl), ether, acetyl, aromatic, ester, hydroxy, alkoxy, cyano, amide, imide, and silyl. Particularly preferred cyclic olefins for use in the present invention include those selected from the following and combinations thereof:

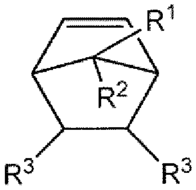 , 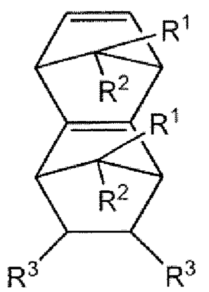 , 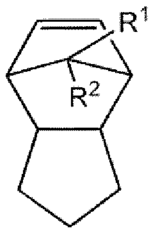 , 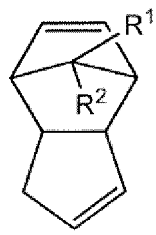 , 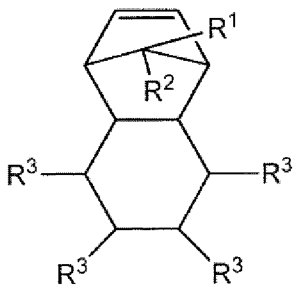 ,

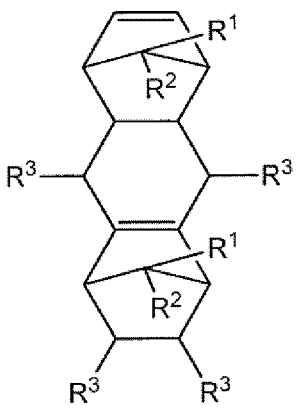 , 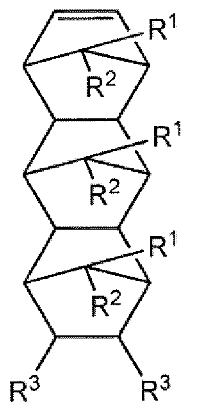 ,

wherein each $R^1$ and $R^2$ is independently selected from H and an alkyl group (preferably $C_1$-$C_{20}$ alkyls, more preferably $C_1$-$C_{10}$ alkyls), and each $R^3$ is independently selected from H, substituted and unsubstituted aryl groups (preferably $C_6$-$C_{18}$ aryls), alkyl groups (preferably $C_1$-$C_{20}$ alkyls, more preferably $C_1$-$C_{10}$ alkyls), cycloalkyl groups (preferably $C_3$-$C_{30}$ cycloalkyl groups, more preferably $C_3$-$C_{18}$ cycloalkyl groups,), aralkyl groups (preferably $C_6$-$C_{30}$ aralkyls, more preferably

$C_6$-$C_{18}$ aralkyl groups, for example benzyl, phenethyl, phenylpropyl, etc.), ester groups, ether groups, acetyl groups, alcohols (preferably $C_1$-$C_{10}$ alcohols), aldehyde groups, ketones, nitriles, and combinations thereof.

Preferred acyclic olefins are selected from branched and unbranched $C_2$-$C_{20}$ alkenes (preferably $C_2$-$C_{10}$ alkenes) . More preferably, the acyclic olefin has the structure of $(R^4)_2C = C(R^4)_2$, wherein each $R^4$ is independently selected from H and alkyl groups (preferably $C_1$-$C_{20}$ alkyls, more preferably $C_1$-$C_{10}$ alkyls). Particularly preferred acyclic olefins for use in the present invention include those selected from ethene, propene, and butene, with ethene being most preferred.

Methods for producing the cyclic olefin copolymer are known in the art. For example, the cyclic olefin copolymer can be produced through chain polymerization of a cyclic monomer and an acyclic monomer. When norbornene reacts with ethene under these conditions, an ethene-norbornene copolymer containing alternating norbornanediyl units and ethylene units is obtained. Examples of copolymers produced by this method include those available under the TOPAS (TM) (produced by Topas Advanced Polymers) and APEL (TM) (produced by Mitsui Chemicals, Inc.) brands. Suitable methods for producing these copolymers are disclosed in US Pat. No. 6,008,298. Cycloolefin copolymers can also be produced through ring-opening metathesis polymerization of various cyclic monomers followed by hydrogenation. Polymers resulting from this type of polymerization can be conceptually considered as a copolymer of ethene and a cyclic olefin monomer (e.g., alternating units of ethylene and cyclopentane-1,3-diyl). Examples of copolymers produced through this ring opening method include those provided under the ZEONOR (TM) (from Zeon Chemicals) and ARTON (TM) (from JSR Corporation) brands. Suitable methods for producing these copolymers through this ring opening method are disclosed in US Pat. No. 5,191,026.

Arylcyclobutene oligomers useful as the curable adhesive material for use in the present invention are well known in the art. Suitable aryl cyclobutene oligomers include, but are not limited to, those having the following formula:

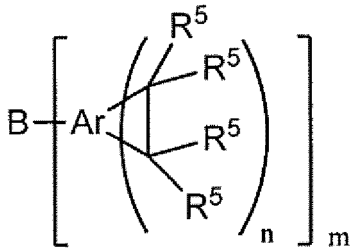

wherein B is an n-valent linking group; Ar is a polyvalent aryl group, and the carbon atoms of the cyclobutene ring are bonded to adjacent carbon atoms on the same aromatic ring as Ar; m is an integer of 1 or more; and n is an integer of 1 or more; and $R^5$ is a monovalent group. Preferably, the polyvalent aryl group Ar may be composed of 1 to 3 aromatic carbocyclic or heteroaromatic rings. The aryl group preferably contains a single aromatic ring, more preferably a phenyl ring. The aryl group is optionally substituted with: one to three groups selected from ($C_1$-$C_6$) alkyl, tri ($C_1$-$C_6$) alkylsilyl, ($C_1$-$C_6$) alkoxy, and halo; preferably one or more of ($C_1$-$C_6$) alkyl, tri ($C_1$-$C_3$) alkylsilyl, ($C_1$-$C_3$) alkoxy, and chloro; and more preferably one or more of ($C_1$-$C_3$) alkyl, tri ($C_1$-$C_3$) alkylsilyl, and ($C_1$-$C_3$) alkoxy. The aryl group is preferably unsubstituted. n = 1 or 2 is preferable, and n = 1 is more preferable. m = 1 to 4 is preferable, m = 2 to 4 is more preferable, and m = 2 is still more preferable. Preferably, $R^5$ is selected from H and ($C_1$-$C_6$) alkyl, more preferably H and ($C_1$-$C_3$) alkyl. Preferably, B has one or more carbon-carbon double bonds (ethylenically unsaturated). Suitable monovalent B groups preferably have the formula $-[C(R^{10}) = CR^{11}]xZ$ wherein $R^{10}$ and $R^{11}$ are independently selected from hydrogen, ($C_1$-$C_6$) alkyl, and aryl; Z is selected from hydrogen, ($C_1$-$C_6$) alkyl, aryl, siloxanyl, and $-CO_2R^{12}$; each $R^{12}$ is independently selected from H, ($C_1$-$C_6$) alkyl, aryl, aralkyl, and alkaryl; and x = 1 or 2. Preferably, $R^{10}$ and $R^{11}$ are independently selected from H, ($C_1$-$C_3$) alkyl, and aryl, more preferably selected from H and ($C_1$-$C_3$) alkyl. $R^{12}$ is preferably ($C_1$-$C_3$) alkyl, aryl, or aralkyl. Z is preferably siloxyl. Preferred siloxyl groups have the formula - $[Si(R^{13})_2$-O]p-$Si(R^{13})_2$-, wherein each $R^{13}$ is independently selected from H, ($C_1$-$C_6$) alkyl, aryl, aralkyl, and alkaryl; and p is an integer of 1 or more. $R^{13}$ is selected from ($C_1$-$C_3$) alkyl, aryl, and aralkyl. Suitable aralkyl groups include benzyl, phenethyl, and phenylpropyl.

Preferably, the aryl cyclobutene oligomer includes one or more oligomers of the following formula:

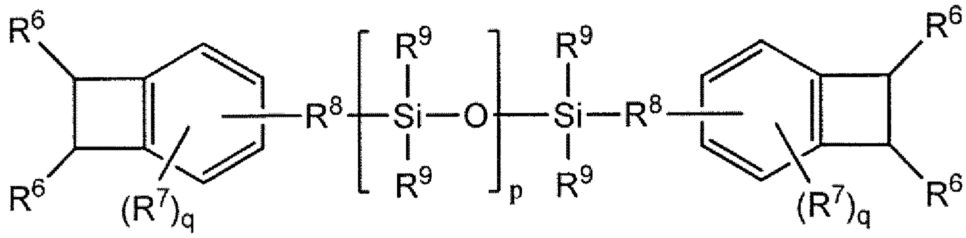

wherein each $R^6$ is independently selected from H and ($C_1$-$C_6$) alkyl, preferably selected from H and ($C_1$-$C_3$) alkyl; each $R^7$ is independently selected from ($C_1$-$C_6$) alkyl, tri ($C_1$-$C_6$) alkylsilyl, ($C_1$-$C_6$) alkoxy, and halo; each $R^8$ is independently a divalent ethylenically unsaturated organic group; each $R^9$ is independently selected from H, ($C_1$-$C_6$) alkyl, aralkyl, and phenyl; p is an integer of 1 or more; and q is an integer of 0 to 3. Each $R^6$ is preferably independently selected from H and ($C_1$-$C_3$) alkyl, and more preferably each $R^6$ is H. Each R7 is preferably independently selected from ($C_1$-$C_6$) alkyl, tri ($C_1$-$C_3$) alkylsilyl, ($C_1$-$C_3$) alkoxy, and chloro, more preferably from ($C_1$-$C_3$) alkyl, tri ($C_1$-$C_3$) alkylsilyl, and ($C_1$-$C_3$) alkoxy. Preferably, each $R^8$ is independently selected from ($C_2$-$C_6$) alkenyl, and more preferably each $R^8$ is -CH = CH-. Each $R^9$ is preferably selected from ($C_1$-$C_3$) alkyl, and more preferably each $R^9$ is methyl. Preferably p = 1 to 5, more preferably p = 1 to 3, and even more preferably p = 1. It is preferable that q = 0. A particularly preferred aryl cyclobutene oligomer, 1,3-bis(2-bicyclo[4.2.0]octa-1,3,5-triene-3-ylethenyl)-1,1,3,3-tetramethyldisiloxane ("DVS-bisBCB"), has the following formula.

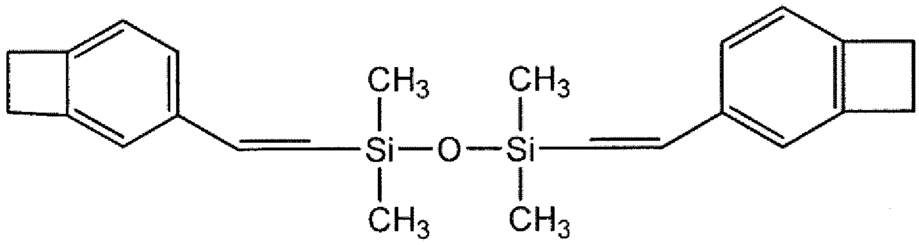

Arylcyclobutene oligomers can be prepared by any suitable method, for example by the method disclosed in US Pat. No. 4,812,588; No. 5,136,069; and No. 5,138,081, and WO 94/25903. Suitable aryl cyclobutene oligomers are also commercially available under CYCLOTENE (TM) brand, which is available from DOW ELECTRONIC MATERIALS. The aryl cyclobutene oligomers may be used as they are or may be further purified by any suitable method.

Vinyl aromatic oligomers that can be cured may be used as the curable adhesive material in the present invention. Such vinyl aromatic oligomers are usually an oligomer of one or more reactive ethylenically unsaturated comonomer and a vinyl aromatic monomer. Preferably, the vinyl aromatic monomer contains one vinyl group. A suitable vinyl aromatic monomer is an unsubstituted vinyl aromatic monomer and a substituted vinyl aromatic monomer, wherein one or more hydrogens are replaced with a substituent selected from the group consisting of ($C_1$-$C_6$) alkyl, ($C_1$-$C_6$) alkoxy, halo, and amino. Exemplary vinyl aromatic monomers include, but are not limited to, styrene, vinyltoluene, vinylxylene, vinylanisole, vinyldimethoxybenzene, vinylaniline, halostyrenes such as fluorostyrene, $\alpha$-methylstyrene, $\beta$-methoxystyrene, ethylvinylbenzene, vinylpyridine, vinylimidazole, vinylpyrrole, and mixtures thereof. Preferred vinyl aromatic monomers are styrene, vinyl toluene, vinyl xylene, vinyl anisole, ethyl vinyl benzene, and mixtures thereof. A preferred reactive comonomer contains, in addition to the olefinic (or ethylenically unsaturated) moiety used to form a vinyl aromatic oligomer, a reactive moiety, i.e. a moiety that is capable of further polymerization (or crosslinking) after forming a vinyl aromatic oligomer, for example, an allylic moiety or a vinyl group. Such a reactive comonomer may preferably be any asymmetric diene or triene that can be further polymerized through Diels-Alder reaction after oligomerization with a vinyl aromatic monomer. More preferably, the reactive comonomer contains an allyl moiety in addition to the ethylenic unsaturation used to form a vinyl aromatic oligomer, and even more preferably contains an allyl ester moiety in addition to this ethylenic unsaturation. Exemplary reactive comonomers useful to form a vinyl aromatic oligomer include, but are not limited to, vinylcyclohexene, vinyl ethers, asymmetric dienes or trienes, such as terpene monomers, dicyclopentadiene, diallyl maleate, allyl acrylate, allyl methacrylate, allyl cinnamate, diallyl fumarate, allyl tigrate, divinylbenzene, and mixtures thereof. Preferred reactive comonomers are diallyl maleate, allyl acrylate, allyl methacrylate, allyl cinnamate, diallyl fumarate, and mixtures thereof, more preferably diallyl maleate, allyl methacrylate, and mixtures thereof. Exemplary terpene monomers include, but are not limited to, limonene, dipentene, myrcene, and the like. It will be appreciated by those skilled in the art that one or more second comonomers may also be used to form a vinyl aromatic oligomer. Such a second comonomer is ethylenically unsaturated, but does not contain any reactive moieties. Exemplary second comonomers include, but are not limited to, (meth) acrylic acid, (meth) acrylamide, (C1-C10) alkyl(meth)acrylate,

aromatic(meth)acrylate, substituted ethylene monomers, and poly(alkyleneoxide) monomers.

The molar ratio of vinyl aromatic monomer : comonomer in such a vinyl aromatic oligomer is preferably 99 : 1 to 1 : 99, more preferably 95 : 5 to 5 : 95, and even more preferably 90 : 10 to 10 : 90. Such vinyl aromatic oligomers may be prepared by any suitable method, for example by any of the methods known in the art. Typically, the vinyl aromatic oligomer is prepared through free radical polymerization of the vinyl aromatic monomer and the comonomers. A preferred vinyl aromatic oligomer contains an unreacted allyl moiety capable of further curing such an oligomer.

A wide variety of materials may be used as the release additive in the temporary bonding composition, and these materials do not react with the adhesive material under the conditions of storage and use, and are non-curable under the conditions used to cure the adhesive material. In addition, the release additive should be compatible with the temporary bonding composition. That is, the release additive should be dispersible, miscible, or otherwise substantially compatible with the adhesive material and any other components used in the temporary bonding composition, for example, organic solvents. When an organic solvent (or mixed solvent system) is used in the temporary bonding composition, the release additive and the curable adhesive material are required to be soluble in such a solvent. The release additive in the present invention is sufficiently non-volatile so that they do not substantially evaporate under the conditions of use. That is, they do not substantially evaporate during the deposition step, for example spin coating, or any subsequent heating step used to remove the organic solvent or to cure the adhesive material. When the film or layer of the temporary bonding composition is cast, for example, by spin coating, a large amount of (or the entirety of) the solvent is evaporated. The release additive is soluble in any organic solvent used, but preferably is not completely soluble in the curable adhesive material. The release additive is more hydrophilic than the cured adhesive material. Without being bound by theory, it is believed that, when the adhesive material is cured, a release additive phase separates and preferentially migrates towards the active surface (the surface that is more hydrophilic than the carrier surface) of the wafer. The use of a suitable hydrophilic moiety in the release additive allows complete dispersion, or preferably dissolution, of the release additive in the temporary bonding composition, and allows phase separation of the release additive when the adhesive material is cured and the release additive moves towards the more hydrophilic surface. No material which does not phase-separate from the adhesive material in curing functions as the release additive according to the present invention.

In general, the release additive contains one or more relatively hydrophilic moieties, such as one or more moieties containing oxygen, nitrogen, phosphorus, and sulfur. Suitable release additives include, but are not limited to: ethers, esters, carboxylates, alcohols, thioethers, thiols, amines, imines, amides, phosphate esters, sulfonate esters, and mixtures thereof. Preferably, the release additive contains one or more polar end groups, which contain one or more of oxygen, nitrogen, and sulfur, preferably oxygen. Exemplary polar end groups include alkoxy, aryloxy, hydroxy, carboxylate, alkoxycarbonyl, mercapto, alkylthio, primary amine, secondary amine, and tertiary amine. Preferred end groups are selected from ($C_1$-$C_6$) alkoxy, ($C_6$-$C_{10}$) aryloxy, hydroxy, carboxylate, ($C_1$-$C_6$) alkoxycarbonyl, mercapto, ($C_1$-$C_6$) alkylthio, amino, ($C_1$-$C_6$) alkylamino, and di ($C_1$-$C_6$) alkylamino, more preferably selected from ($C_1$-$C_6$) alkoxy, ($C_6$-$C_{10}$) aryloxy, hydroxy, carboxylate, and (C1-C6) alkoxycarbonyl, even more preferably selected from ($C_1$-$C_6$) alkoxy, hydroxy, carboxylate, and ($C_1$-$C_6$) alkoxycarbonyl. Particularly preferred polar end groups are selected from hydroxy, methoxy, ethoxy, propoxy, butoxy, carboxyl, and acetoxy. Preferably, the release additive contains no silicon.

A suitable release additive has a number average molecular weight (Mn) of ≤ 10,000 Daltons, preferably ≤ 7500 Daltons, more preferably ≤ 7000 Daltons. The release additive has a minimum molecular weight (Mn) sufficient to render the release additive substantially non-volatile during the conditions of use (That is, < 50, preferably < 3%, more preferably ≤ 1% of the release additive volatilizes during use.). Preferably, the release additive has a Mn of ≥ 500 Daltons. The preferred range of Mn is 500 to 10,000 Daltons, more preferably 500 to 7500 Daltons, even more preferably 500 to 7000 Daltons. The release additive may be a linear polymer; a branched polymer, such as a dendritic polymer, a star-like polymer, etc; and a polymer particle. The release additive is preferably a linear polymer or a polymer particle, and more preferably a linear polymer. Without being bound by theory, it is believed that a linear polymer can move better through the curable adhesive material phase towards the hydrophilic wafer surface as compared to a branched polymer.

The release additive is preferably a polyether. The polyether compounds include alkylene oxide homopolymers and alkylene oxide copolymers. Such copolymers may be random or block. The polyalkylene oxide release additive may have a variety of polar end groups. Preferably, such polar end groups are hydroxy, ($C_1$-$C_6$) alkoxy, and ($C_1$-$C_6$) alkoxycarbonyl, more preferably hydroxy, ($C_1$-$C_3$) alkoxy, and acetoxy. Preferred polyether compounds are polyglycols (or polyalkylene oxides), for example poly ($C_1$-$C_4$) alkylene oxide compounds, which may have a single type of alkylene oxide repeating unit or two or more different alkylene oxide repeating units. Preferred polyether compounds include polyethylene glycol, polypropylene glycol, poly (1,3-propanediol), poly (tetrahydrofuran), ethylene oxide-propylene oxide copolymers, ethylene oxide-butylene oxide copolymers, and mixtures thereof. Preferably, when the release additive has butylene oxide as a repeating unit, it is a copolymer with one or more different alkylene oxide repeating units. Those skilled in the art appreciate that a mixture of release additives may be used in the temporary bonding composition of the present invention. Suitable release additives include polyethers sold under the product name PLURONIC (TM), TETRONIC, and POLYTHF (available from BASF, Ludwigshafen, Germany), product name FORTEGRA (THE DOW CHEMICAL COMPANY, based in Midland, Michigan), and product name TERATHANE (available from Invista, based in Wichita,

Kansas), all of which may be used without further purification.

<<Third Embodiment>>

As a preferred embodiment, the adhesive composition of the present invention contains, for example, a thermosetting polymer described below.

For the adhesive composition of the third embodiment, for example, the thermosetting polymer described in Japanese Patent No. 6528747 can be used.

The thermosetting polymer is not particularly limited, and preferable examples thereof include a siloxane bond-containing polymer (hereinafter, also referred to as silicone A) having a weight average molecular weight of 3,000 to 500,000 and having: a repeating unit represented by the following formula (3); and, as necessary, a repeating unit represented by the following formula (4):

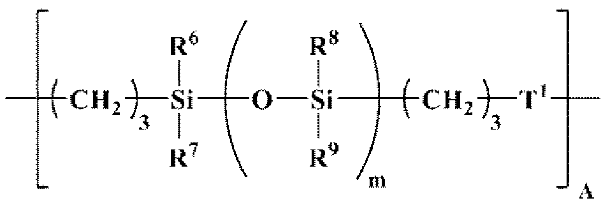

(3)

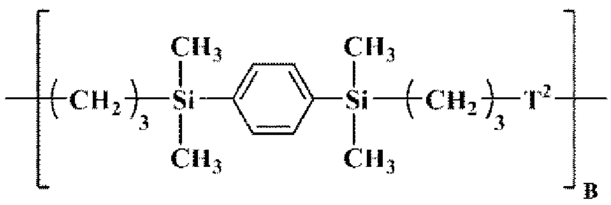

(4)

wherein $R^6$ to $R^9$ each independently represent a monovalent hydrocarbon group having 1 to 8 carbon atoms; m represents an integer of 1 to 100; A and B are positive numbers satisfying $0 < A < 1$, $0 < B < 1$, and $A + B = 1$; $T^1$ and $T^2$ are a divalent organic group represented by the following formula (5);

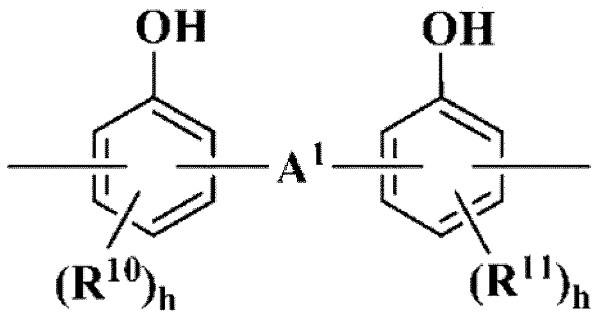

(5)

wherein $A^1$ is a single bond or a divalent organic group selected from the groups represented by the following formula:

$-CH_2-$ , 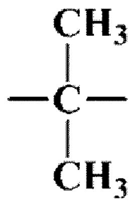 , 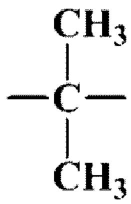 , and 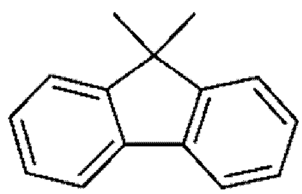

wherein $R^{10}$ and $R^{11}$ are each independently an alkyl group or alkoxy group having 1 to 4 carbon atoms; and h is each independently 0, 1, or 2.

Examples of the monovalent hydrocarbon group represented by $R^6$ to $R^9$ include alkyl groups, such as a methyl group and an ethyl group, and aryl groups, such as a phenyl group. m is preferably an integer of 3 to 60, more preferably 8 to 40. In addition, A is preferably 0.3 to 0.8, B is preferably 0.2 to 0.7, and A/B preferably satisfies 0.1 to 20 and more preferably satisfies 0.5 to 5.

Preferable examples of the thermosetting polymer include a siloxane bond-containing polymer (hereinafter, also referred to as silicone B) having a weight average molecular weight of 3,000 to 500,000 and having: a repeating unit represented by the following formula (6); and, as necessary, a repeating unit represented by the following formula (7):

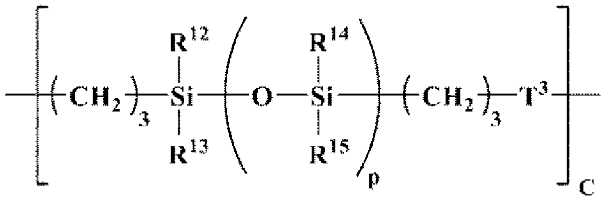

(6)

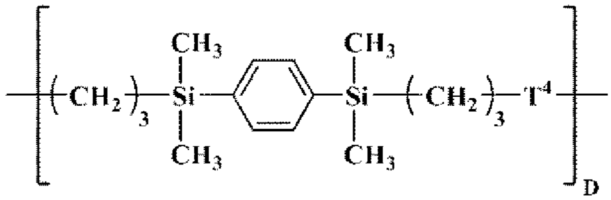

(7)

wherein $R^{12}$ to $R^{15}$ each independently represent a monovalent hydrocarbon group having 1 to 8 carbon atoms; p represents an integer of 1 to 100; C and D are a positive number satisfying $0 < C \leq 1$, $0 \leq D < 1$, and $C + D = 1$; and $T^3$ and $T^4$ are a divalent organic group represented by the following formula (8):

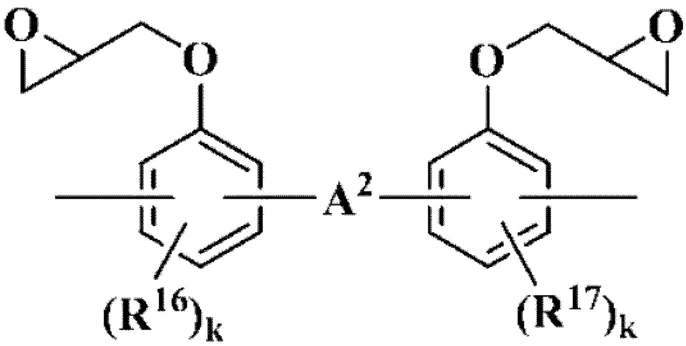

(8)

wherein $A^2$ is a single bond or a divalent organic group selected from the groups represented by the following formula:

$-CH_2-$ , 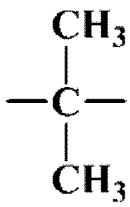 , 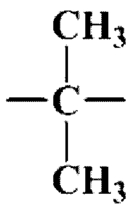 , and 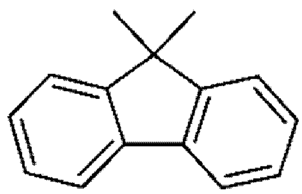

wherein $R^{16}$ and $R^{17}$ are each independently an alkyl group or alkoxy group having 1 to 4 carbon atoms; and k is each independently 0, 1, or 2.

In this case, examples of the monovalent hydrocarbon group represented by $R^{11}$ to $R^{14}$ include the same groups as those exemplified as those represented by $R^5$ to $R^8$. p is preferably an integer of 3 to 60, more preferably 8 to 40. In addition, C is preferably 0.3 to 1, D is preferably 0 to 0.7, and C + D = 1.

The adhesive layer formed using the thermosetting polymer as the adhesive composition of the third embodiment is preferably a layer of the cured product of a thermosetting resin composition containing the silicone A or the silicone B as a main component. The silicone A and the silicone B can be used in combination. In this case, the ratio (polymerization ratio) is preferably silicone A : silicone B = 0.1 : 99.9 to 99.9 : 0.1, and more preferably silicone A : silicone B = 20 : 80 to 80 : 20.

The thermosetting resin composition containing the silicone A as a main component contains, for its thermal curing, one or more crosslinking agents selected from an amino condensate modified with formalin or formalin-alcohol, a phenol compound having two or more methylol groups or alkoxymethylol groups on average in one molecule, and an epoxy compound having two or more epoxy groups on average in one molecule.

On the other hand, the thermosetting resin composition containing the silicone B as a main component contains one or more crosslinking agents selected from a phenol compound having two or more phenol groups on average in one molecule and an epoxy compound having two or more epoxy groups on average in one molecule for thermal curing thereof.

In addition, the thermosetting resin composition containing the silicone A and the silicone B contains one or more crosslinking agents selected from epoxy compounds having two or more epoxy groups on average in one molecule for thermal curing thereof.

Examples of the amino condensate include a melamine resin and a urea resin. Examples of the melamine resin modified with formalin or formalin-alcohol include ones obtained by the following: a modified melamine monomer (for example, trimethoxymethyl monomethylol melamine) or a multimer thereof (for example, oligomers such as dimers and trimers) are subjected to an addition condensation polymerization with formaldehyde according to a known method to have a desired molecular weight. These can be used singly or in combination of two or more kinds thereof.

Examples of the urea resin modified with formalin or formalin-alcohol include methoxymethylated urea condensates, ethoxymethylated urea condensates, propoxymethylated urea condensates, and the like. These can be used singly or in combination of two or more kinds thereof. The urea resin modified with formalin or formalin-alcohol can be prepared by, for example, methylol formation modification of a urea condensate having a desired molecular weight with formalin, or further alkoxylation modification thereof with an alcohol, according to a known method.

Examples of the phenol compound having two or more methylol groups or alkoxymethylol groups on average in one molecule include (2-hydroxy-5-methyl)-1,3-benzenedimethanol and 2,2',6,6'-tetramethoxymethylbisphenol A. These can be used singly or in combination of two or more kinds thereof.

The epoxy compound having two or more epoxy groups on average in one molecule is not particularly limited. Examples thereof include: bifunctional, trifunctional, or tetrafunctional or higher polyfunctional epoxy resins, such as EOCN-1020 (see the following formula), EOCN-102S, XD-1000, NC-2000-L, EPPN-201, GAN, and NC6000, which are manufactured by Nippon Kayaku Co., Ltd.; and compounds represented by the following formulas.

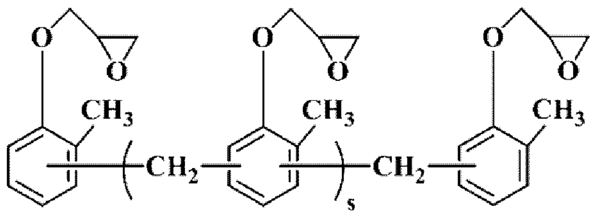

s=3~6

**EOCN-1020**

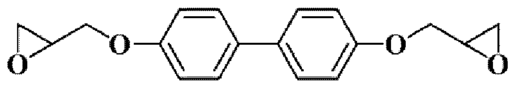

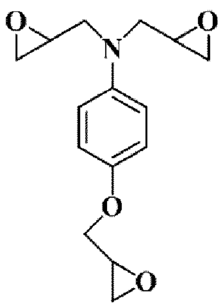

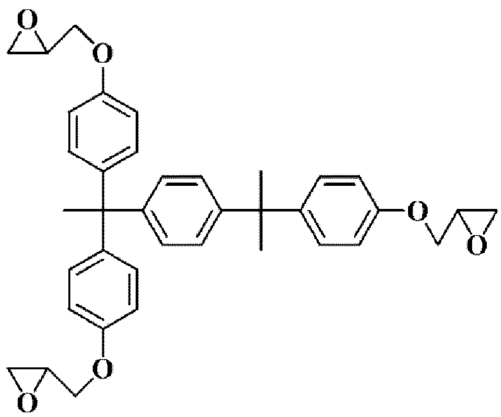

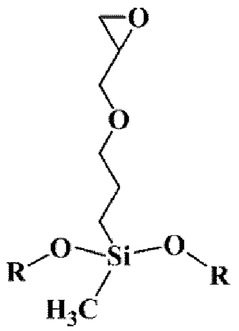

R = methyl group or ethyl group

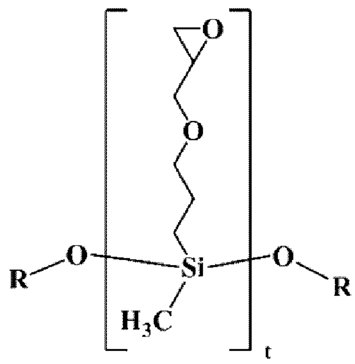

R = methyl group or ethyl group

| | |
|---|---|
| t=1 | 20 wt% |
| t=2 | 75 wt% |
| t≧3 | 5 wt% |

Examples of the phenol compound having two or more phenol groups on average in one molecule include m- or p-cresol novolac resins (for example, EP-6030G, which is manufactured by ASAHI YUKIZAI KOGYO), trifunctional phenol compounds (for example, Tris-P-PA, which is manufactured by Honshu Chemical Industry Co., Ltd.), and tetrafunctional phenol compounds (for example, TEP-TPA, which is manufactured by ASAHI YUKIZAI KOGYO).

The blending amount of the crosslinking agent in the thermosetting resin composition is preferably 0.1 to 50 parts by mass, more preferably 0.2 to 30 parts by mass, and still more preferably 1 to 20 parts by mass, based on 100 parts by mass of the thermosetting polymer. The crosslinking agent can be used singly or in combination of two or more kinds thereof.

In the thermosetting resin composition, a curing catalyst such as an acid anhydride may be blended in an amount of 10 parts by mass or less based on 100 parts by mass of the thermosetting polymer.

<<Fourth Embodiment>>

As a preferred embodiment, the adhesive composition of the present invention is, for example, a thermoplastic composition described below.

In the adhesive composition of the fourth embodiment, for example, as the thermoplastic composition for forming a bonding composition layer described in Japanese Patent No. 5788173 (hereinafter, referred to as "bonding composition"), a compound selected from the group consisting of polymers and oligomers of imide, amideimide, and amideimide-siloxane can be used.

The compound is, for example, selected from the group consisting of a polymer and an oligomer having a repeating unit of at least one of the following formula (I) and the following formula (II):

Formula (I):

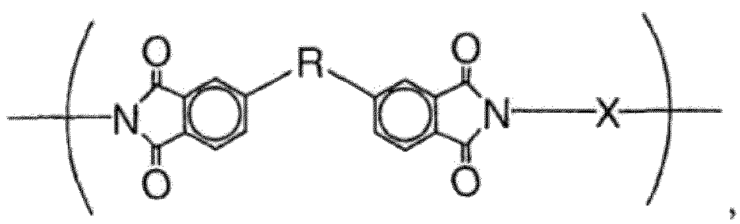

wherein, R is selected from the group consisting of:

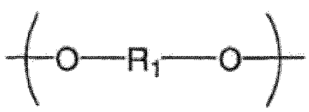 , 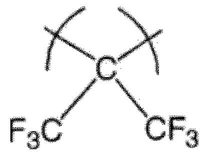 , and 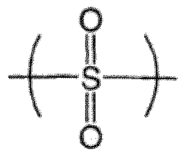 ,

wherein $R_1$ is selected from the group consisting of: an alkyl-substituted phenyl,

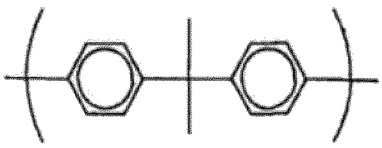 , and 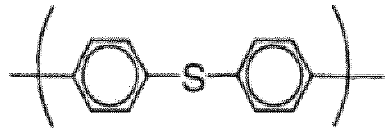 ;

Formula (II):

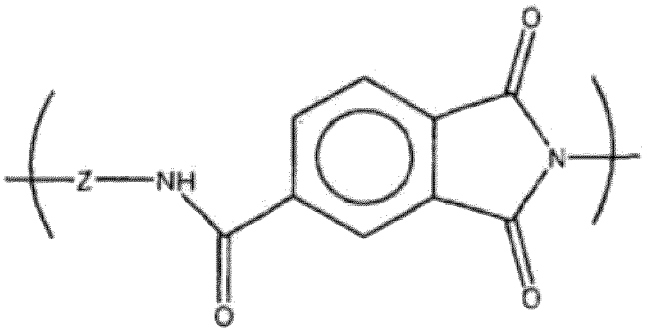 ,

wherein Z is selected from the group consisting of a siloxane and a moiety having an ether bridge.

A preferred alkyl-substituted phenyl is a $C_1$-$C_6$ alkyl-substituted phenyl. Particularly preferred examples of the alkyl-substituted phenyl is selected from the group consisting of:

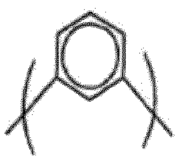 , 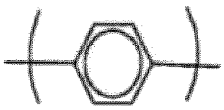 , and 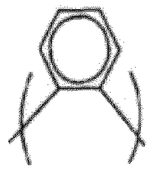 .

In the formula (I), X is selected from the group consisting of phenyl sulfone, (preferably $C_6$ to $C_{60}$, more preferably $C_6$ to $C_{30}$, further preferably $C_6$ to $C_{24}$) aromatic compounds, (preferably $C_2$ to $C_{15}$, more preferably $C_2$ to $C_{10}$, even more preferably $C_2$ to $C_6$) aliphatic compounds, and (preferably $C_4$ to $C_{60}$, more preferably $C_4$ to $C_{20}$, even more preferably $C_4$ to $C_{12}$) alicyclic compounds.

In an embodiment, X may be an aromatic group, an aliphatic group, or an alicyclic group as described above. In another embodiment, X may include an aromatic group having an ether bridge (as discussed with respect to Z) or an aromatic group having a linking group and/or an $-NH_2$ group in the meta position.

Particularly preferred X groups are selected from the group consisting of alkyl-substituted phenyl (as described above), isopropylidenediphenyl, and hexafluoroisopropylidene.

In the embodiment where Z is a siloxane in the formula (II), preferred siloxanes are represented by the formula:

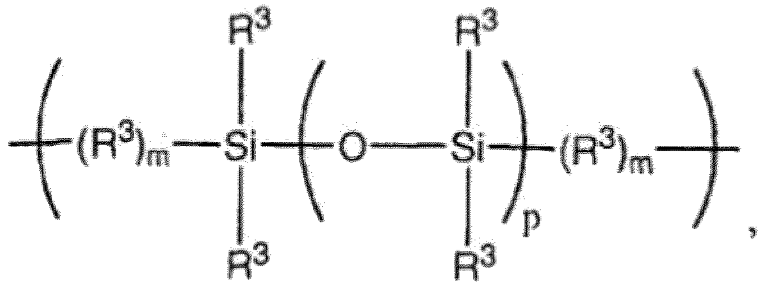

wherein each $R^3$ is individually selected from the group consisting of hydrogen, (preferably $C_1$ to $C_{10}$, more preferably $C_1$ to $C_2$) alkyl, and phenyl;
m is 1 to 6; and
p is 1 to 50, preferably 1 to 20, and more preferably 1 to 10.

In the formula (II), preferred moieties having an ether bridge as Z are selected from the group consisting of:

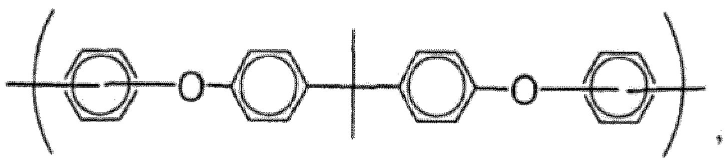

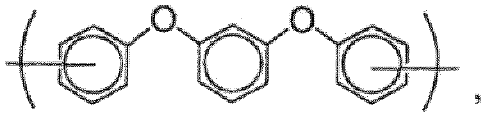

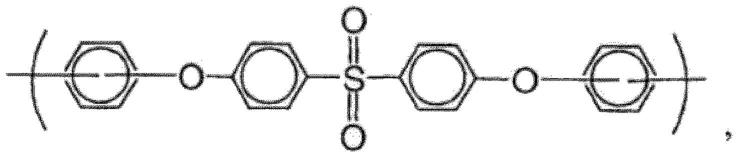

and

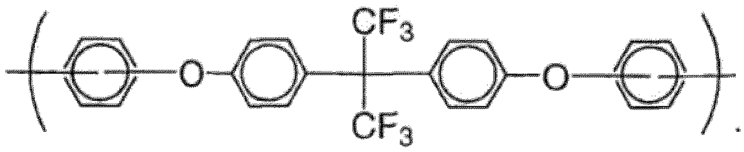

In the embodiment of the formula (I) or the formula (II), it is preferable that the polymer or oligomer further has a terminal blocking group. Preferred terminal blocking groups are derived from compounds selected from the group consisting of aromatic monoamines, aliphatic monoamines, alicyclic monoamines, and phthalic anhydride. Particularly preferred terminal blocking groups have a group selected from the group consisting of (preferably $C_1$ to $C_{15}$, more preferably $C_1$ to $C_{10}$, even more preferably $C_1$ to $C_6$) alkyl,

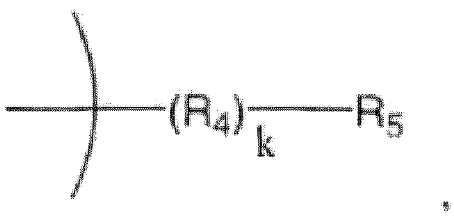

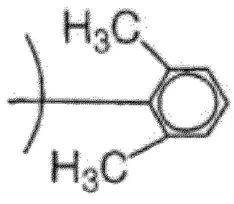, and 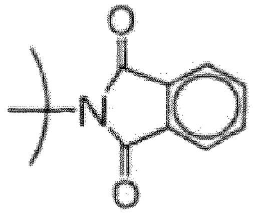,

wherein $R_4$ is (preferably $C_1$ to $C_{15}$, more preferably $C_1$ to $C_{10}$, even more preferably $C_1$ to $C_6$) alkyl; $R_5$ is (preferably $C_3$ to $C_{12}$, more preferably $C_5$ to $C_6$) alicyclic group; and
k is 0 to 20, preferably 0 to 10, more preferably 0 to 5.

The compound may be a polymer or an oligomer.

The polymeric or oligomeric compound is thermoplastic, and preferably has a weight average molecular weight of about 3000 Daltons to about 300000 Daltons, more preferably about 6000 Daltons to about 50000 Daltons. Preferred compounds preferably have a softening temperature (at a melt viscosity of 3000 Pa·s) of at least about 150°C, more preferably at least about 200°C, and even more preferably about 200°C to about 250°C.

The adhesive composition of the present invention may contain a solvent for the purpose of adjusting the viscosity. Specific examples thereof include aliphatic hydrocarbons, aromatic hydrocarbons, and ketones, but are not limited thereto.

More specific examples of the solvent include hexane, heptane, octane, nonane, decane, undecane, dodecane, isododecane, menthane, limonene, toluene, xylene, mesitylene, cumene, MIBK (methyl isobutyl ketone), butyl acetate, diisobutyl ketone, 2-octanone, 2-nonanone, and 5-nonanone, but are not limited thereto. Such solvents can be used singly or in combination of two or more kinds thereof.

When the adhesive composition of the present invention contains a solvent, the content thereof is appropriately determined in consideration of the desired viscosity of the composition, the coating method to be employed, the thickness of the film to be produced, and the like, and is in a range of about 10 to 90 mass% with respect to the entire composition.

An example of the adhesive composition of the present invention can be produced by mixing the component (A) with the component (B) and a solvent, which are optionally used.

The mixing order is not particularly limited, and an example of the method by which the adhesive composition can be easily and reproducibly produced include, but are not limited to, a method in which the component (A) and the component (B) are dissolved in a solvent, and a method in which a part of the component (A) and the component (B) are dissolved in a solvent, the rest is dissolved in a solvent, and the resulting solutions are mixed. When the adhesive composition is prepared, heating may be appropriately performed as long as the components are not decomposed or altered.

In the present invention, for the purpose of removing foreign substances, a solvent, a solution, or the like to be used may be filtered using a filter or the like during the production of the adhesive composition or after mixing all the components.

The adhesive composition may be used for permanent adhesion of two substrates, or may be used for temporary adhesion of two substrates.

Permanent adhesion is such that an adhesive layer formed from the adhesive composition is present and interposed between the two substrates in the final product. The permanent adhesion is, for example, adhesion between an object to be applied and an object to be joined in display panel production, as described in JP 2014-221892 A.

Temporary adhesion of substrates is temporary adhesion of two substrates for processing one of the two substrates. Therefore, the two substrates temporarily bonded through the adhesive composition are released after one of the substrates is processed. Examples of the temporary adhesion include temporary adhesion of a substrate whose back surface is to be processed (for example, processing such as grinding processing, TSV processing, and electrode formation) to a support substrate, as described in JP 2021-14507 A. In addition, the temporary adhesion may be, for example, temporary adhesion to a support substrate for processing a warped substrate (for example, a wafer), as described in Japanese Patent No. 6167984.

(Laminate)

The laminate of the present invention includes a first substrate, a second substrate, and an adhesive layer, and further includes other layers such as a release layer and an inorganic material layer as necessary.

<First substrate>

The first substrate is not particularly limited as long as it is a substrate constituting the laminate together with the second substrate.
The material, shape, size, and structure of the first substrate are not particularly limited.
The first substrate may be made of an organic material, an inorganic material, or both an organic material and an inorganic material.
The first substrate is, for example, a substrate having a semiconductor (Hereinafter, it may be referred to as "semiconductor substrate".).
The semiconductor substrate is a substrate having a semiconductor material (for example, silicon, silicon carbide, and compound semiconductor) in the manufacturing process of a semiconductor product (for example, an integrated circuit (IC), a large scale integration (LSI), or the like). Examples thereof include a semiconductor wafer on which a circuit is formed, and a substrate obtained by resin-molding a chip obtained by dicing the wafer.
An example of the semiconductor substrate is described below.
The main material constituting the entire semiconductor substrate is not particularly limited, and examples thereof include silicon, silicon carbide, and a compound semiconductor.
The shape of the semiconductor substrate is not particularly limited, and is, for example, a disk shape. Note that the disk-shaped semiconductor substrate does not need to have a completely circular surface. For example, the outer periphery of the semiconductor substrate may have a straight portion called an orientation flat or may have a cut called a notch.
The thickness of the disk-shaped semiconductor substrate may be appropriately determined according to the purpose of use of the semiconductor substrate and the like, and is not particularly limited, and is, for example, 500 to 1,000 um.
The diameter of the disk-shaped semiconductor substrate may be appropriately determined according to the purpose of use of the semiconductor substrate and the like, and is not particularly limited, and is, for example, 100 to 1,000 mm.
The semiconductor substrate may have a bump. The bump is a protruding terminal.
In the laminate, when the semiconductor substrate has a bump, the semiconductor substrate has the bump on the support substrate side.
In the semiconductor substrate, the bump is usually formed on a surface on which a circuit is formed. The circuit may be a single layer or a multilayer. The shape of the circuit is not particularly limited.
In the semiconductor substrate, the surface (back surface) opposite to the surface having a bump is a surface to be processed.
The material, size, shape, structure, and density of the bump the semiconductor substrate has are not particularly limited.
Examples of the bump include a ball bump, a printed bump, a stud bump, and a plated bump.
Usually, the height, diameter, and pitch of the bump are appropriately determined from the conditions of a bump height of about 1 to 200 um, a bump diameter of 1 to 200 um, and a bump pitch of 1 to 500 um.
Examples of the material of the bump include low-melting-point solder, high-melting-point solder, tin, indium, gold, silver, and copper. The bump may be composed only of a single component or may be composed of a plurality of components. More specific examples thereof include an alloy plating mainly containing Sn, such as SnAg bumps, SnBi bumps, Sn bumps, and AuSn bumps.
In addition, the bump may have a layered structure having a metal layer composed of at least one of these components.
An example of the semiconductor substrate is a silicon wafer having a diameter of about 300 mm and a thickness of about 770 $\mu$m.

<Second substrate>

The second substrate is not particularly limited as long as it is a substrate constituting a laminate together with the first substrate.
The material, shape, size, and structure of the second substrate are not particularly limited.
The second substrate may be made of an organic material, an inorganic material, or both an organic material and an inorganic material.
The second substrate is, for example, a support substrate that supports the first substrate when the first substrate is processed.
The support substrate is not particularly limited as long as it is a member capable of supporting the first substrate when the first substrate is processed. Examples thereof include a glass support substrate and a silicon support substrate.

The shape of the support substrate is not particularly limited, and examples thereof include a disk shape. Note that the disk-shaped support substrate does not need to have a complete circular surface. For example, the outer periphery of the support substrate may have a straight portion called an orientation flat or may have a cut called a notch.
The thickness of the disk-shaped support substrate may be appropriately determined according to the size of the semiconductor substrate and the like, and is not particularly limited, and is, for example, 500 to 1,000 um.
The diameter of the disk-shaped support substrate may be appropriately determined according to the size of the semiconductor substrate and the like, and is not particularly limited, and is, for example, 100 to 1,000 mm.
An example of the support substrate is a glass wafer or a silicon wafer having a diameter of 300 mm and a thickness of about 700 μm.

<Adhesive layer>

The adhesive layer is provided between the first substrate and the second substrate.
The adhesive layer is a layer formed from the adhesive composition of the present invention.
The method for forming the adhesive layer from the adhesive composition of the present invention is described in detail in the description of (Method of manufacturing laminate) described below.
The thickness of the adhesive layer is not particularly limited, and is usually 5 to 500 μm, and is preferably 10 μm or more, more preferably 20 um or more, still more preferably 30 um or more from the viewpoint of maintaining the film strength, and is preferably 200 um or less, more preferably 150 um or less, still more preferably 120 um or less, still more preferably 70 um or less from the viewpoint of avoiding nonuniformity caused by being a thick film.

<Release layer>

The laminate of the present invention may include a release layer.
When the laminate has a release layer, the release layer is provided between the first substrate and the second substrate.
When the laminate has a release layer, for example, the release layer can be disposed so as to be in contact with the second substrate and the adhesive layer.
The release layer is not particularly limited as long as the release layer can be peeled off by heating, light irradiation, or mechanical force to contribute to separation of the first substrate and the second substrate in the laminate. For example, the release layer described below can be used.
In a preferred embodiment, the release layer is a film obtained from a release agent composition containing an organic resin and a solvent. In an embodiment, the film is a cured film obtained by curing the film constituent components in the release agent composition.
The release agent composition may further contain a crosslinking agent, an acid catalyst, and a surfactant.

<<Organic resin>>

The release agent composition contains an organic resin. Such an organic resin is preferably one that can exhibit a suitable release ability. In the case of separating the first substrate and the second substrate by light-irradiating the release layer, the organic resin absorbs light and suitably undergoes a deterioration that is necessary to improve release ability, for example, decomposition.
A preferred example of the organic resin includes a novolac resin.
When the release layer included in the laminate of the present invention is peeled off by light-irradiation, a novolak resin that absorbs light having a wavelength of 190 nm to 600 nm and is altered is preferable, and a novolak resin that is altered by irradiation with light such as a laser having a wavelength of 308 nm, 343 nm, 355 nm, or 365 nm is more preferable.
As a specific example, the novolac resin is a polymer containing one kind or two or more kinds selected from the group consisting of a unit represented by the following formula (C1-1), a unit represented by the following formula (C1-2), and a unit represented by the following formula (C1-3).

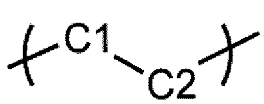 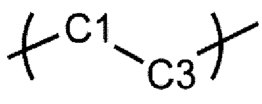 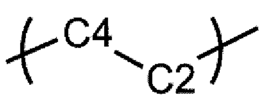

Formula (C1-1) Formula (C1-2) Formula (C1-3)

C1 represents a group derived from an aromatic compound containing a nitrogen atom. C2 represents a group containing a tertiary carbon atom having at least one selected from the group consisting of a secondary carbon atom, a quaternary carbon atom, and an aromatic ring in its side chain. C3 represents a group derived from an aliphatic polycyclic compound. C4 represents a group derived from phenol, a group derived from bisphenol, a group derived from naphthol, a group derived from biphenyl, or a group derived from biphenol.

For the novolac resin to be contained in the release agent composition and the release layer using the novolac resin, the novolac resin described in WO 2019/088103 and the release layer using the novolac resin may be taken into consideration.

In another preferred embodiment, the release layer is a film obtained from a release agent composition containing a polyorganosiloxane and, if necessary, a solvent.

The polyorganosiloxane may be a commercially available product or may be synthesized.

Examples of commercially available products of the polyorganosiloxane include trade name AK 50, which is manufactured by Wacker Chemie AG.

The thickness of the release layer included in the laminate according to the present invention is appropriately determined in consideration of the type of the release agent component, the degree of desired release property, and the like, and is usually 5 to 10,000 nm, and is preferably 10 nm or more, more preferably 50 nm or more, and still more preferably 100 nm or more from the viewpoint of suppressing deterioration of release performance due to being a thin film, reproducibly obtaining a release layer excellent in release property, and the like, and is preferably 5,000 nm or less, more preferably 1,000 nm or less, and still more preferably 500 nm or less from the viewpoint of avoiding non-uniformity due to being a thick film, and the like.

<<Crosslinking agent>>

The release agent composition may contain a crosslinking agent. When the release agent composition contains a crosslinking agent, crosslinking between resins suitably proceeds and suitable curing can be realized, depending on the type of resins contained together. As a result, it is possible to reproducibly obtain a film that cannot be suitably removed with an organic solvent, an acid, and a chemical solution (alkali developer, hydrogen peroxide water, and the like) used in the production of a semiconductor element but can be suitably removed with a cleaning agent composition.

Specific typical examples of such a crosslinking agent include, but are not particularly limited to, a phenol-based crosslinking agent, a melamine-based crosslinking agent, a urea-based crosslinking agent, a thiourea-based crosslinking agent, and the like having a crosslinking group such as a hydroxymethyl group and an alkoxymethyl group such as a methoxymethyl group and a butoxymethyl group in the molecule. These may be a low-molecular-weight compound or a polymer compound.

The crosslinking agent contained in the release agent composition usually has two or more crosslinking groups. From the viewpoint of reproducibly realizing more suitable curing, the number of crosslinking groups contained in the compound as the crosslinking agent is preferably 2 to 10, and more preferably 2 to 6.

The crosslinking agent contained in the release agent composition preferably has an aromatic ring (for example, a benzene ring or a naphthalene ring) in the molecule from the viewpoint of achieving higher heat resistance, and typical examples of such a crosslinking agent include, but are not limited to, phenolic crosslinking agents.

The phenolic crosslinking agent having a crosslinking group is a compound having a crosslinking group bonded to an aromatic ring and having at least one of a phenolic hydroxyl group and an alkoxy group derived from a phenolic hydroxyl group. Examples of such an alkoxy group derived from a phenolic hydroxyl group include a methoxy group and a butoxy group, but are not limited thereto.

The aromatic ring to which the crosslinking group is bonded and the aromatic ring to which the phenolic hydroxyl group and/or the alkoxy group derived from a phenolic hydroxyl group is bonded are not limited to a non-condensed aromatic ring such as a benzene ring, and may be a condensed aromatic ring, such as a naphthalene ring and anthracene.

When a plurality of aromatic rings are present in the molecule of the phenolic crosslinking agent, the crosslinking group and the phenolic hydroxyl group and the alkoxy group derived from a phenolic hydroxyl group may be bonded to the same aromatic ring in the molecule or may be bonded to different aromatic rings.

The aromatic ring to which the crosslinking group and the phenolic hydroxyl group and the alkoxy group derived from a phenolic hydroxyl group are bonded may be further substituted with: an alkyl group such as a methyl group, an ethyl group, or a butyl group; a hydrocarbon group such as an aryl group such as a phenyl group; a halogen atom such as a fluorine atom; or the like.

For example, specific examples of the phenolic crosslinking agent having a crosslinking group include compounds represented by any of formulas (L1) to (L4):

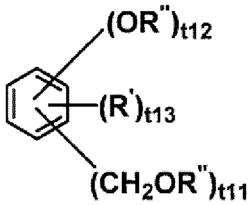

(L1)

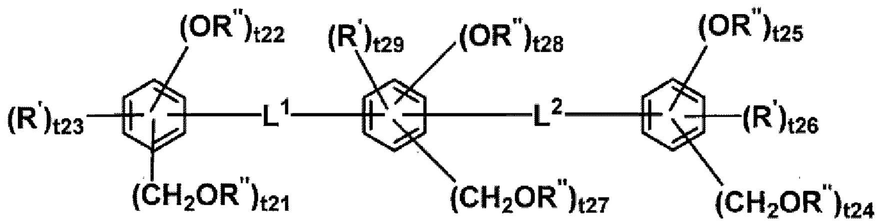

(L2)

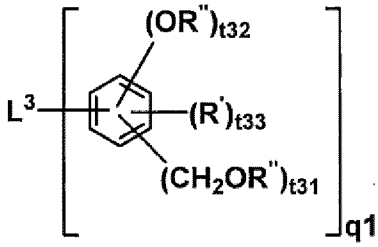

(L3)

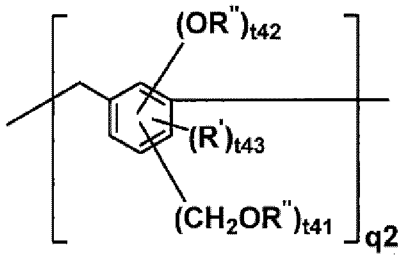

(L4)

wherein each R' independently represents a fluorine atom, an aryl group, or an alkyl group, each R" independently represents a hydrogen atom or an alkyl group, $L^1$ and $L^2$ each independently represent a single bond, a methylene group, or a propane-2,2-diyl group, $L^3$ is determined according to q1 and represents a single bond, a methylene group, a propane-2,2-diyl group, a methantriyl group, or an ethane -1,1,1-triyl group, t11, t12, and t13 are integers satisfying $2 \leq t11 \leq 5$, $1 \leq t12 \leq 4$, $0 \leq t13 \leq 3$, and $t11 + t12 + t13 \leq 6$, t21, t22, and t23 are integers satisfying $2 \leq t21 \leq 4$, $1 \leq t22 \leq 3$, $0 \leq t23 \leq 2$, and $t21 + t22 + t23 \leq 5$, t24, t25, and t26 are integers satisfying $2 \leq t24 \leq 4$, $1 \leq t25 \leq 3$, $0 \leq t26 \leq 2$, and $t24 + t25 + t26 \leq 5$, t27, t28, and t29 are integers satisfying $0 \leq t27 \leq 4$, $0 \leq t28 \leq 4$, $0 \leq t29 \leq 4$, and $t27 + t28 + t29 \leq 4$, t31, t32, and t33 are integers satisfying $2 \leq t31 \leq 4$, $1 \leq t32 \leq 3$, $0 \leq t33 \leq 2$, and $t31 + t32 + t33 \leq 5$, t41, t42, and t43 are integers satisfying $2 \leq t41 \leq 3$, $1 \leq t42 \leq 2$, $0 \leq t43 \leq 1$, and $t41 + t42 + t43 \leq 4$, q1 is 2 or 3, q2 represents the number of repetitions and is an integer of 0 or more, and specific examples of the aryl group and the alkyl group include those same as the following specific examples, and the aryl group is preferably a phenyl group, and the alkyl group is preferably a methyl group or a t-butyl group.

Specific examples of the compounds represented by the formulae (L1) to (L4) are given below, but the compounds are not limited thereto. These compounds may be synthesized by a known method, and can also be obtained, for example, as a product from ASAHI YUKIZAI KOGYO or Honshu Chemical Industry Co., Ltd.

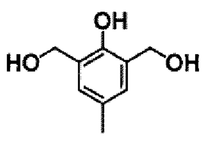

(L1)

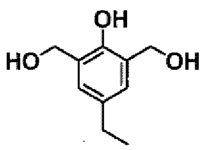

(L2)

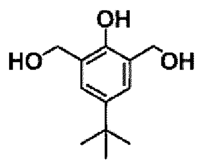

(L3)

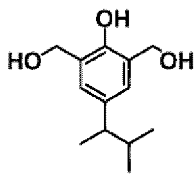

(L4)

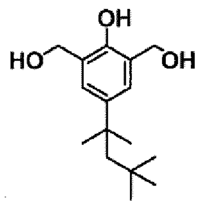

(L5)

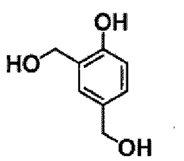

(L6)

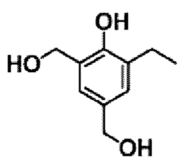

(L7)

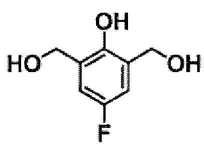

(L8)

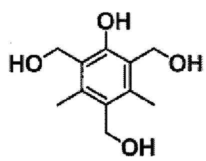

(L9)

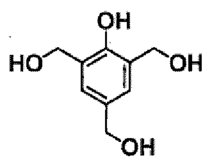

(L10)

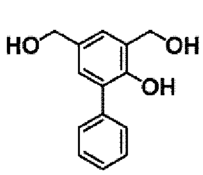
(L11)

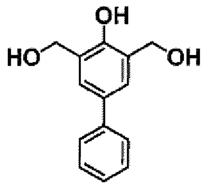
(L12)

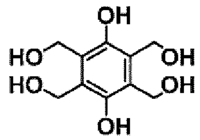
(L13)

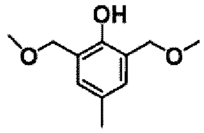
(L1M)

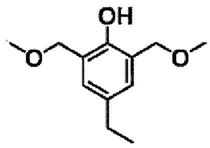
(L2M)

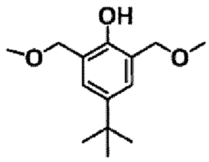
(L3M)

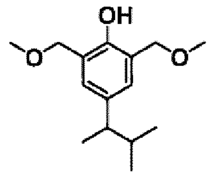
(L4M)

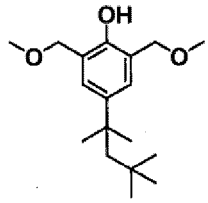
(L5M)

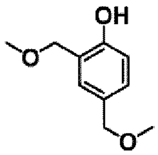
(L6M)

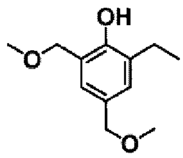
(L7M)

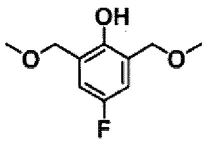
(L8M)

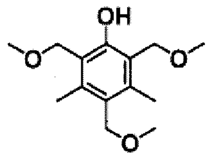
(L9M)

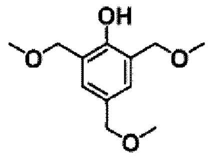
(L10M)

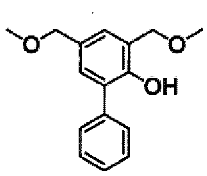
(L11M)

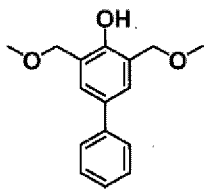
(L12M)

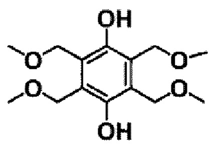
(L13M)

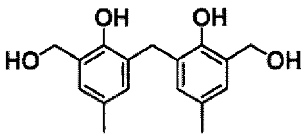
(L14)

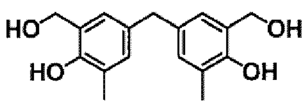
(L15)

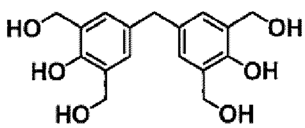
(L16)

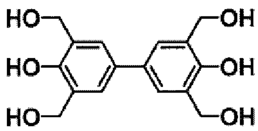
(L17)

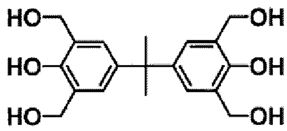
(L18)

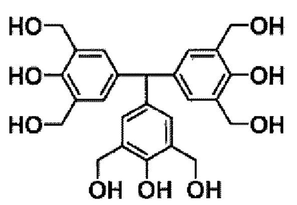
(L19)

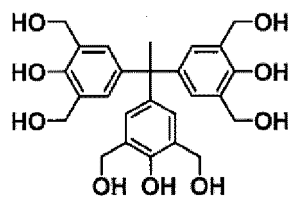
(L20)

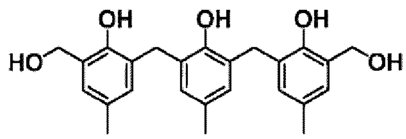
(L21)

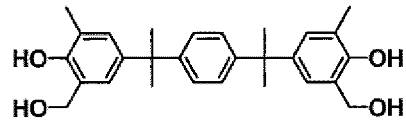
(L22)

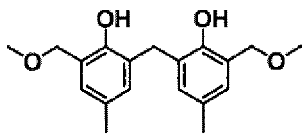
(L14M)

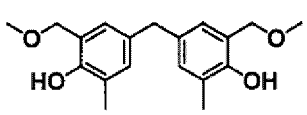
(L15M)

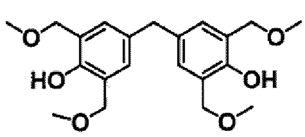
(L16M)

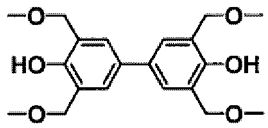
(L17M)

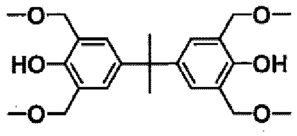
(L18M)

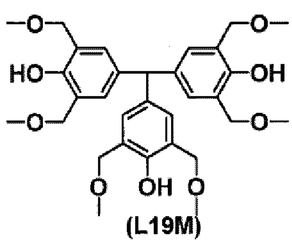
(L19M)

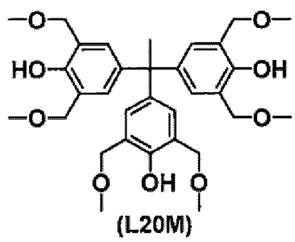
(L20M)

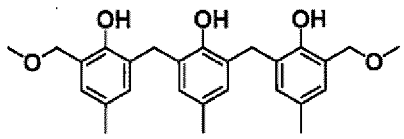
(L21M)

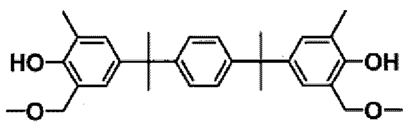
(L22M)

The melamine-based crosslinking agent having a crosslinking group is a melamine derivative, a 2,4-diamino -1,3,5-triazine derivative, or a 2-amino-1,3,5-triazine derivative in which at least one of hydrogen atoms of an amino group bonded to the triazine ring thereof is substituted with a crosslinking group, and the triazine ring may further have a substituent such as an aryl group such as a phenyl group.

Specific examples of the melamine-based crosslinking agent having a crosslinking group include, but are not limited to, mono, bis, tris, tetrakis, pentakis, or hexakis alkoxymethylmelamine, such as N,N,N',N',N",N"-hexakis(methoxymethyl)melamine and N,N,N',N',N",N"-hexakis(butoxymethyl)melamine, and mono, bis, tris, or tetrakis alkoxymethylbenzoguanamine, such as N,N,N',N'-tetrakis(methoxymethyl)benzoguanamine and N,N,N',N'-tetrakis(butoxymethyl)benzoguanamine.

The urea-based crosslinking agent having a crosslinking group is a derivative of a urea bond-containing compound, and has a structure in which at least one of the hydrogen atoms of the NH groups constituting a urea bond is

substituted with a crosslinking group.

Specific examples of the urea-based crosslinking agent having a crosslinking group include: mono, bis, tris, or tetrakis alkoxymethylglycoluril, such as 1,3,4,6-tetrakis(methoxymethyl)glycoluril and 1,3,4,6-tetrakis(butoxymethyl)glycoluril; mono, bis, tris, or tetrakis alkoxymethylurea, such as 1,3-bis(methoxymethyl)urea and 1,1,3,3-tetrakis methoxymethylurea; and the like, but are not limited thereto.

The thiourea-based crosslinking agent having a crosslinking group is a derivative of a thiourea bond-containing compound, and has a structure in which at least one of the hydrogen atoms of the NH groups constituting a thiourea bond is substituted with a crosslinking group.

Specific examples of the thiourea-based crosslinking agent having a crosslinking group include mono, bis, tris, or tetrakis alkoxymethylthiourea, such as 1,3-bis (methoxymethyl)thiourea and 1,1,3,3-tetrakis methoxymethylthiourea, but are not limited thereto.

The amount of the crosslinking agent contained in the release agent composition varies depending on the coating method to be employed, the desired film thickness, and the like, and thus cannot be generally defined, and is usually 0.001 to 80 mass% with respect to the film constituent components, and is preferably 0.01 mass% or more, more preferably 0.05 mass% or more, still more preferably 0.5 mass% or more, still more preferably 1.0 mass% or more, and preferably 50 mass% or less, more preferably 40 mass% or less, still more preferably 20 mass% or less, still more preferably 10 mass% or less from the viewpoint of realizing suitable curing and reproducibly obtaining the laminate in which the first substrate and the second substrate can be satisfactorily separated.

<<Acid generator and acid>>

For the purpose of, for example, promoting the crosslinking reaction, the release agent composition may contain an acid generator or an acid.

Examples of the acid generator include a thermal acid generator and a photoacid generator.

The thermal acid generator is not particularly limited as long as an acid is generated by heat, and specific examples thereof include 2,4,4,6-tetrabromocyclohexadienone, benzoin tosylate, 2-nitrobenzyl tosylate, K-PURE [registered trademark] CXC-1612, K-PURE CXC-1614, K-PURE TAG-2172, K-PURE TAG-2179, K-PURE TAG-2678, K-PURE TAG2689, and K-PURE TAG2700 (manufactured by King Industries, Inc.), SI-45, SI-60, SI-80, SI-100, SI-110, and SI-150 (manufactured by SANSHIN CHEMICAL INDUSTRY CO.,LTD.), and other organic sulfonic acid alkyl esters, but are not limited thereto.

Examples of the photoacid generator include an onium salt compound, a sulfonimide compound, and a disulfonyldiazomethane compound.

Specific examples of the onium salt compound include iodonium salt compounds such as diphenyliodonium hexafluorophosphate, diphenyliodonium trifluoromethanesulfonate, diphenyliodonium nonafluoronormal butanesulfonate, diphenyliodonium perfluoronormal octanesulfonate, diphenyliodonium camphor sulfonate, bis(4-tert-butylphenyl)iodonium camphor sulfonate, and bis(4-tert-butylphenyl)iodonium trifluoromethanesulfonate; and sulfonium salt compounds such as triphenylsulfonium hexafluoroantimonate, triphenylsulfonium nonafluoronormal butanesulfonate, triphenylsulfonium camphor sulfonate, and triphenylsulfonium trifluoromethanesulfonate, but are not limited thereto.

Specific examples of the sulfonimide compound include N-(trifluoromethanesulfonyloxy)succinimide, N-(nonafluoronormalbutanesulfonyloxy)succinimide, N-(camphorsulfonyloxy)succinimide, and N-(trifluoromethanesulfonyloxy)naphthalimide, but are not limited thereto.

Specific examples of the disulfonyl diazomethane compound include bis(trifluoromethylsulfonyl) diazomethane, bis(cyclohexylsulfonyl) diazomethane, bis(phenylsulfonyl) diazomethane, bis(p-toluenesulfonyl) diazomethane, bis(2,4-dimethylbenzenesulfonyl) diazomethane, methylsulfonyl-p-toluenesulfonyl diazomethane, and the like, but are not limited thereto.

Specific examples of the acid include arylsulfonic acids and pyridinium salts, such as p-toluenesulfonic acid, pyridinium p-toluenesulfonic acid (pyridinium p-toluenesulfonate), pyridinium trifluoromethanesulfonate, pyridinium phenolsulfonic acid, 5-sulfosalicylic acid, 4-phenolsulfonic acid, 4-chlorobenzenesulfonic acid, benzenedisulfonic acid, and 1-naphthalenesulfonic acid, and salts thereof; arylcarboxylic acids, such as salicylic acid, benzoic acid, hydroxybenzoic acid, and naphthalenecarboxylic acid, and salts thereof; chain or cyclic alkylsulfonic acids, such as trifluoromethanesulfonic acid and camphorsulfonic acid, and salts thereof; and chain or cyclic alkylcarboxylic acids, such as citric acid, and salts thereof, but are not limited thereto.

The amount of the acid generator and the acid contained in the release agent composition cannot be generally specified since they vary depending on the type of the crosslinking agent to be used together, the heating temperature at the time of forming a film, and the like, and is usually 0.01 to 5 mass% with respect to the film constituent components.

<<<Surfactant>>>

The release agent composition may contain a surfactant for the purpose of, for example, adjusting the liquid physical properties of the composition itself or the film physical properties of the resulting film, or reproducibly preparing a highly uniform release agent composition.

Examples of the surfactant include nonionic surfactants, such as: polyoxyethylene alkyl ethers, such as polyoxyethylene lauryl ether, polyoxyethylene stearyl ether, polyoxyethylene cetyl ether, and polyoxyethylene oleyl ether, polyoxyethylene alkyl allyl ethers, such as polyoxyethylene octyl phenol ether and polyoxyethylene nonyl phenol ether, polyoxyethylene/polyoxypropylene block copolymers, sorbitan fatty acid esters, such as sorbitan monolaurate, sorbitan monopalmitate, sorbitan monostearate, sorbitan monooleate, sorbitan trioleate, and sorbitan tristearate, polyoxyethylene sorbitan fatty acid esters, such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine-based surfactants, such as EFUTOP EF301, EF303, and EF352 (trade name, manufactured by TOKEM PRODUCTS), MEGAFAC F171, F173, R-30, and R-30N (trade name, manufactured by DIC Corporation), FRORARD FC430, FC431 (trade name, manufactured by Sumitomo 3M Limited), and AsahiGuard AG710, Surflon S-382, SC101, SC102, SC103, SC104, SC105, and SC106 (trade name, manufactured by Asahi Glass Co., Ltd.); and KP 341, an organosiloxane polymer (manufactured by Shin-Etsu Chemical Co., Ltd.).

The surfactant can be used singly or in combination of two or more kinds thereof.

The amount of the surfactant is usually 2 mass% or less with respect to the film constituent components of the release agent composition.

<<Solvent>>

The release agent composition preferably contains a solvent.

As such a solvent, for example, a highly polar solvent capable of satisfactorily dissolving film constituent components such as the organic resin and the crosslinking agent can be used. As necessary, a low polar solvent may be used for the purpose of adjusting viscosity, surface tension, and the like. In the present invention, it is defined that the low polar solvent has a relative permittivity of less than 7 at a frequency of 100 kHz and the highly polar solvent has a relative permittivity of 7 or more at a frequency of 100 kHz. The solvent can be used singly or in combination of two or more kinds thereof.

Examples of the highly polar solvent include amide-based solvents, such as N,N-dimethylformamide, N,N-dimethylacetamide, N,N-dimethylisobutylamide, N-methylpyrrolidone, and 1,3-dimethyl-2-imidazolidinone; ketone-based solvents, such as ethyl methyl ketone, isophorone, and cyclohexanone; cyano-based solvents, such as acetonitrile and 3-methoxypropionitrile; polyhydric alcohol-based solvents, such as ethylene glycol, diethylene glycol, triethylene glycol, dipropylene glycol, 1,3-butanediol, and 2,3-butanediol;
monohydric alcohol-based solvents other than aliphatic alcohols, such as propyleneglycol monomethylether, diethyleneglycol monomethylether, diethyleneglycol monophenylether, triethyleneglycol monomethylether, dipropyleneglycol monomethylether, benzyl alcohol, 2-phenoxyethanol, 2-benzyloxyethanol, 3-phenoxybenzyl alcohol, and tetrahydrofurfuryl alcohol; and sulfoxide-based solvents, such as dimethyl sulfoxide.

Examples of the low-polarity solvent include chlorine-based solvents, such as chloroform and chlorobenzene; aromatic hydrocarbon-based solvents, such as alkylbenzenes, such as toluene, xylene, tetralin, cyclohexylbenzene, and decylbenzene; aliphatic alcohol-based solvents, such as 1-octanol, 1-nonanol, and 1-decanol; ether-based solvents, such as tetrahydrofuran, dioxane, anisole, 4-methoxytoluene, 3-phenoxytoluene, dibenzyl ether, diethyleneglycol dimethylether, diethyleneglycol butylmethylether, triethyleneglycol dimethylether, and triethyleneglycol butylmethylether; ester-based solvents, such as methyl benzoate, ethyl benzoate, butyl benzoate, isoamyl benzoate, bis(2-ethylhexyl) phthalate, dibutyl maleate, dibutyl oxalate, hexyl acetate, propyleneglycol monomethylether acetate, diethyleneglycol monoethylether acetate, and diethyleneglycol monobutylether acetate.

The content of the solvent is appropriately determined in consideration of the desired viscosity of the composition, the coating method to be adopted, the thickness of the film to be prepared, and the like, and is 99 mass% or less with respect to the entire composition, and preferably 70 to 99 mass% with respect to the entire composition. That is, the amount of the film constituent components in that case is 1 to 30 mass% with respect to the entire composition.

The viscosity and surface tension of the release agent composition are appropriately adjusted by changing the type of the solvent to be used, the ratio thereof, the concentration of the film constituent components, and the like in consideration of various factors such as the coating method to be used and the desired film thickness.

In an embodiment of the present invention, the release agent composition contains a glycol-based solvent from the viewpoint of reproducibly obtaining a highly uniform composition, from the viewpoint of reproducibly obtaining a composition with high storage stability, from the viewpoint of reproducibly obtaining a composition that provides a highly uniform film, and the like. The term "glycol-based solvent" as used herein is a generic term for glycols, glycol monoethers,

glycol diethers, glycol monoesters, glycol diesters, and glycol ester ethers.

An example of a preferred glycol-based solvent is represented by the formula (G).

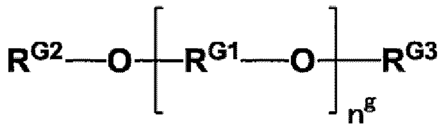 (G)

In the formula (G), $R^{G1}$ each independently represents a linear or branched alkylene group having 2 to 4 carbon atoms, $R^{G2}$ and $R^{G3}$ each independently represent a hydrogen atom, a linear or branched alkyl group having 1 to 8 carbon atoms, or an alkylacyl group in which the alkyl moiety is a linear or branched alkyl group having 1 to 8 carbon atoms, and $n^g$ is an integer of 1 to 6.

Specific examples of the linear or branched alkylene group having 2 to 4 carbon atoms include, but are not limited to, an ethylene group, a trimethylene group, a 1-methylethylene group, a tetramethylene group, a 2-methylpropane-1,3-diyl group, a pentamethylene group, and a hexamethylene group.

Among them, a linear or branched alkylene group having 2 to 3 carbon atoms is preferable, and a linear or branched alkylene group having three carbon atoms is more preferable from the viewpoint of reproducibly obtaining a highly uniform composition, from the viewpoint of reproducibly obtaining a composition with high storage stability, from the viewpoint of reproducibly obtaining a composition that provides a highly uniform film, and the like.

Specific examples of the linear or branched alkyl group having 1 to 8 carbon atoms include a methyl group, an ethyl group, a n-propyl group, an i-propyl group, a n-butyl group, an i-butyl group, a s-butyl group, a tertiary butyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a n-hexyl, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, but are not limited thereto.

Among them, a methyl group and an ethyl group are preferable, and a methyl group is more preferable from the viewpoint of reproducibly obtaining a highly uniform composition, from the viewpoint of reproducibly obtaining a composition with high storage stability, from the viewpoint of reproducibly obtaining a composition that provides a highly uniform film, and the like.

Specific examples of the linear or branched alkyl group having 1 to 8 carbon atoms in the alkylacyl group in which the alkyl moiety is a linear or branched alkyl group having 1 to 8 carbon atoms include the same as the specific examples described above.

Among them, a methylcarbonyl group and an ethylcarbonyl group are preferable, and a methylcarbonyl group is more preferable from the viewpoint of reproducibly obtaining a highly uniform composition, from the viewpoint of reproducibly obtaining a composition with high storage stability, from the viewpoint of reproducibly obtaining a composition that provides a highly uniform film, and the like.

$n^g$ is preferably 4 or less, more preferably 3 or less, still more preferably 2 or less, and most preferably 1 from the viewpoint of reproducibly obtaining a highly uniform composition, from the viewpoint of reproducibly obtaining a composition with high storage stability, from the viewpoint of reproducibly obtaining a composition that provides a highly uniform film, and the like.

In the formula (G), preferably, at least one of $R^{G2}$ and $R^{G3}$ is a linear or branched alkyl group having 1 to 8 carbon atoms, more preferably, one of $R^{G2}$ and $R^{G3}$ is a linear or branched alkyl group having 1 to 8 carbon atoms, and the other is a hydrogen atom or an alkylacyl group in which the alkyl moiety is a linear or branched alkyl group having 1 to 8 carbon atoms, from the viewpoint of reproducibly obtaining a highly uniform composition, from the viewpoint of reproducibly obtaining a composition with high storage stability, from the viewpoint of reproducibly obtaining a composition that provides a highly uniform film, and the like.

The content of the glycol-based solvent is preferably 50 mass% or more, more preferably 70 mass% or more, still more preferably 80 mass% or more, still more preferably 90 mass% or more, and still more preferably 95 mass% or more, with respect to the solvent contained in the release agent composition, from the viewpoint of reproducibly obtaining a highly uniform composition, from the viewpoint of reproducibly obtaining a composition with high storage stability, from the viewpoint of reproducibly obtaining a composition that provides a highly uniform film, and the like.

In the release agent composition, the film constituent components are uniformly dispersed or dissolved in the solvent, and preferably dissolved, from the viewpoint of reproducibly obtaining a highly uniform composition, from the viewpoint of reproducibly obtaining a composition with high storage stability, from the viewpoint of reproducibly obtaining

a composition that provides a highly uniform film, and the like.

<Inorganic material layer>

The laminate may have an inorganic material layer.

The inorganic material layer is usually interposed between the release layer and the adhesive layer. The inorganic material layer suppresses mixing of the release layer and the adhesive layer.

The inorganic material layer is not particularly limited as long as it is a layer formed of an inorganic material. Examples thereof include a layer formed of a compound such as an oxide, a nitride, and a carbide of at least one element selected from the group consisting of silicon, boron, titanium, zirconium, and aluminum, and a mixture thereof.

Preferably, the inorganic material layer is a layer obtained by plasma-polymerizing an organosilicon compound.

The inorganic material layer is formed by, for example, chemical vapor deposition (CVD) method. For example, plasma polymerization coating is performed by chemical vapor deposition method.

Examples of the material used for the plasma polymerization coating include organosilicon compounds. For example, by performing plasma polymerization coating with an organosilicon compound on the release layer or the adhesive layer, a source material gas containing the organosilicon compound can be decomposed to form the inorganic material layer, which is a thin film containing a Si-O bond on the release layer or the adhesive layer.

It is preferable that an oxygen-containing gas, such as $O_2$ or $N_2O$ is blended in the source gas containing the organosilicon compound. In addition, a rare gas such as argon or helium may be blended in the source gas as a carrier gas. In a preferred example of the method for decomposing the source gas, using a plasma generator, the source gas is decomposed by the generated plasma under an appropriate pressure condition. Incidentally, a technique of decomposing a source material gas using plasma to form a film (layer) may be generally referred to as a plasma polymerization method.

Examples of the organosilicon compound include a siloxane compound, a disilazane compound, and a silane compound.

Examples of the siloxane compound include: chain siloxanes, such as 1,1,3,3-tetramethyldisiloxane, pentamethyldisiloxane, hexamethyldisiloxane, 1,1,3,3-tetraphenyl-1,3-dimethyldisiloxane, 1,3-divinyltetramethyldisiloxane, 1,1,3,3,5,5-hexamethyltrisiloxane, 1,1,1,3,5,5,5-heptamethyltrisiloxane, octamethyltrisiloxane, 1,1,1,3,5,7,7,7-octamethyltetrasiloxane, decamethyltetrasiloxane, and 1,1,5,5-tetraphenyl-1,3,3,5-tetramethyltrisiloxane; and cyclic siloxanes, such as hexamethylcyclotrisiloxane, 1,3,5,7-tetramethylcyclotetrasiloxane, octamethylcyclotetrasiloxane, decamethylcyclopentasiloxane, and 1,3,5,7-tetravinyl-1,3,5,7-tetramethylcyclotetrasiloxane.

Examples of the disilazane compound include 1,1,3,3-tetramethyldisilazane, hexamethyldisilazane, heptamethyldisilazane, hexamethylcyclotrisilazane, and 1,1,3,3,5,5,7,7-octamethylcyclotetrasilazane.

Examples of the silane compound include methylsilane, dimethylsilane, trimethylsilane, tetramethylsilane, trimethoxysilane, triethylsilane, trichloromethylsilane, dichlorodimethylsilane, chlorotrimethylsilane, tetramethoxysilane, trimethoxymethylsilane, ethyltrimethoxysilane, dimethoxydimethylsilane, methoxytrimethylsilane, tetraethoxysilane, triethoxymethylsilane, triethoxyethylsilane, diethoxydimethylsilane, ethoxytrimethylsilane, diethoxymethylsilane, ethoxydimethylsilane, acetoxytrimethylsilane, allyloxytrimethylsilane, allyltrimethylsilane, butoxytrimethylsilane, butyltrimethoxysilane, diacetoxydimethylsilane, dimethoxydiphenylsilane, diethoxydiphenylsilane, dimethoxymethylphenylsilane, ethoxydimethylvinylsilane, diphenylsilanediol, triacetoxymethylsilane, triacetoxyethylsilane, 3-glycidyloxypropyltrimethoxysilane, hexyltrimethoxysilane, 3-mercaptopropyltrimethoxysilane, octadecyltriethoxysilane, triethoxyoctylsilane, triethoxyphenylsilane, trimethylphenylsilane, propoxytrimethylsilane, triethoxypropylsilane, tetraacetoxysilane, tetrabutoxysilane, tetrapropoxysilane, triacetoxyvinylsilane, triethoxyvinylsilane, trimethoxyvinylsilane, triphenylsilanol, trimethylvinylsilane, tris(2-methoxyethoxy)vinylsilane, and the like.

The thickness of the inorganic material layer is not particularly limited, and is usually 1 to 1,000 nm, and preferably 100 to 500 nm.

Hereinafter, an example of the laminate is described with reference to the drawings.

Fig. 1 is a schematic cross-sectional view of an example of the laminate.

The laminate of Fig. 1 includes a first substrate 1, an adhesive layer 2, and a second substrate 3 in this order.

The adhesive layer 2 is interposed between the first substrate 1 and the second substrate 3. The adhesive layer 2 is in contact with the first substrate 1 and the second substrate 3.

Fig. 2 is a schematic cross-sectional view of another example of the laminate.

The laminate of Fig. 2 includes a first substrate 1, an adhesive layer 2, a release layer 4, and a second substrate 3 in this order.

The adhesive layer 2 is interposed between the first substrate 1 and the second substrate 3. The adhesive layer 2 is in contact with the first substrate 1 and the release layer 4.

The release layer 4 is interposed between the first substrate 1 and the second substrate 3. The release layer 4 is in contact with the adhesive layer 2 and the second substrate 3.

The laminate of the another example may include the first substrate 1, the release layer 4, the adhesive layer 2, and the second substrate 3 in this order.
Fig. 3 is a schematic cross-sectional view of another example of the laminate.
The laminate of Fig. 3 includes a first substrate 1, an adhesive layer 2, an inorganic material layer 5, a release layer 4, and a second substrate 3 in this order.
The adhesive layer 2 is interposed between the first substrate 1 and the second substrate 3. The adhesive layer 2 is in contact with the first substrate 1 and the inorganic material layer 5.
The release layer 4 is interposed between the first substrate 1 and the second substrate 3. The release layer 4 is in contact with the inorganic material layer 5 and the second substrate 3.
The inorganic material layer 5 is interposed between the first substrate 1 and the second substrate 3. The inorganic material layer 5 is in contact with the adhesive layer 2 and the release layer 4.
The laminate of the another example may include the first substrate 1, the release layer 4, the inorganic material layer 5, the adhesive layer 2, and the second substrate 3 in this order.
In the laminate of another examples, another layer may be further provided at least between a substrate and a layer or between a layer and a layer in Figs. 1 to 3.
The laminate of the present invention is suitably produced, for example, by the method of manufacturing a laminate of the present invention, as follows.

(Method of manufacturing laminate)

The method of manufacturing a laminate of the present invention includes, for example, a release layer-forming step, an adhesive coating layer-forming step, and an adhesive layer-forming step, and further includes other steps such as an inorganic material layer-forming step and a bonding step as necessary.

<Release layer-forming step>

The release layer-forming step is a step of forming the release layer.
When the release agent composition to be used contains no solvent, for example, the release layer is formed by applying the release agent composition onto the first substrate or the second substrate. Heating may be performed in the process of forming the layer as necessary for the purpose of softening the layer to improve adhesion to the substrate, and the like.
When the release agent composition to be used contains a solvent, for example, the release agent composition is applied onto the first substrate or the second substrate to form a release agent coating layer, and the release agent coating layer is heated to remove the solvent, whereby the release layer is formed. Since the solvent is removed along with film formation by spinning, or the like, if there is no need, heating may not be performed in the process of forming the layer.
The applying method is not particularly limited, and is usually a spin coating method.
The heating temperature is appropriately determined according to the boiling point of the solvent and the purpose of heating, and is usually 50 to 250°C. The heating time is appropriately determined according to the heating temperature, and is usually 30 seconds to 1 hour.
The heating can be performed using, for example, an oven or a hot plate.

<Inorganic material layer-forming step>

The inorganic material layer-forming step is not particularly limited as long as it is a step of forming the inorganic material layer. Examples thereof include a step including the method for forming an inorganic material layer described above in the description of the inorganic material layer.

<Adhesive coating layer-forming step>

The adhesive coating layer-forming step is not particularly limited as long as it is a step of forming the adhesive coating layer. Examples thereof include a step including a method of applying the adhesive composition onto the first substrate, the release layer, the inorganic material layer, or the second substrate, and then performing heating (preheating treatment) to form an adhesive coating layer, which is an uncured or uncompletely cured adhesive layer. In this way, the adhesive coating layer is formed, for example, on the first substrate, the release layer, the inorganic material layer, or the second substrate.
The applying method is not particularly limited, and is usually a spin coating method. Incidentally, it is possible to employ a method of separately forming a coating film by a spin coating method or the like and attaching the sheet-like coating film as the adhesive coating layer.

The thickness of the adhesive coating layer is appropriately determined in consideration of the thickness of the adhesive layer in the laminate and the like.

When the adhesive composition contains a solvent, the applied adhesive composition is usually heated (preheating treatment).

The heating temperature of the applied adhesive composition varies depending on the type and amount of the adhesive component contained in the adhesive composition, whether or not a solvent is contained, the boiling point of the solvent used, the desired thickness of the adhesive layer, and the like, and thus cannot be generally specified. It is usually 80 to 150°C, and the heating time is usually 30 seconds to 5 minutes.

The heating can be performed using, for example, a hot plate or an oven.

<Adhesive layer-forming step>

The adhesive layer-forming step is not particularly limited as long as it is a step of heating the adhesive coating layer to form the adhesive layer (post-heating treatment).

For example, the first substrate on which the adhesive coating layer is formed and the second substrate on which the release layer is formed are used, and the two substrates (the first substrate and the second substrate) are disposed so as to sandwich the two layers (the adhesive coating layer and the release layer), so that the adhesive coating layer and the release layer are brought into contact with each other, and then a heat treatment may be performed. In addition, for example, the first substrate on which the release layer and the adhesive coating layer are formed and the second substrate are used, and the two substrates (the first substrate and the second substrate) are disposed so as to sandwich the two layers (the release layer and the adhesive coating layer), so that the second substrate and the adhesive coating layer are brought into contact with each other, and then a heat treatment may be performed. For example, the first substrate on which the release layer is formed and the second substrate on which the adhesive coating layer is formed are used, and the two substrates (the first substrate and the second substrate) are disposed so as to sandwich the two layers (the release layer and the adhesive coating layer), so that the release layer and the adhesive coating layer are brought into contact with each other, and then a heat treatment may be performed.

For example, the first substrate on which the release layer, the inorganic material layer, and the adhesive coating layer are formed and the second substrate are used, and the two substrates (the first substrate and the second substrate) are disposed so as to sandwich the three layers (the release layer, the inorganic material layer, and the adhesive coating layer), so that the second substrate and the adhesive coating layer are brought into contact with each other, and then a heat treatment may be performed. Alternatively, for example, the first substrate on which the release layer and the inorganic material layer are formed and the second substrate on which the adhesive coating layer is formed are used, and the two substrates (the first substrate and the second substrate) are disposed so as to sandwich the three layers (the release layer, the inorganic material layer, and the adhesive coating layer), so that the inorganic material layer and the adhesive coating layer are brought into contact with each other, and then a heat treatment may be performed.

The temperature and time of the heating are not particularly limited as long as the temperature and time allow the adhesive coating layer to convert into the adhesive layer.

The heating temperature is preferably 120°C or higher from the viewpoint of achieving a sufficient curing rate, and is preferably 260°C or lower from the viewpoint of preventing the deterioration of each layer (including the second substrate and the first substrate) constituting the laminate.

The heating time is preferably 1 minute or more, and more preferably 5 minutes or more from the viewpoint of realizing suitable joining of the layers (including the second substrate and the first substrate) constituting the laminate, and is preferably 180 minutes or less, and more preferably 120 minutes or less from the viewpoint of suppressing or avoiding adverse effects on the layers due to excessive heating.

The heating can be performed using, for example, a hot plate or an oven.

The heating may be performed in stages.

<Bonding step>

Usually, the bonding step is performed between the adhesive coating layer-forming step and the adhesive layer-forming step in order to sufficiently bond the first substrate and the second substrate.

The bonding step is a step of bonding the first substrate and the second substrate under heating and pressurization so that the first substrate and the second substrate are in contact with each other through the adhesive coating layer.

The bonding step is not particularly limited as long as a substrate and a layer can be bonded to each other and the substrate and the layer are not damaged. Typically, the bonding step is a step in which heating and loading in the thickness direction of the first substrate and the second substrate are performed. More preferably, the bonding step is a step in which heating and loading in the thickness direction of the first substrate and the second substrate are performed

under reduced pressure.

The heating temperature is not particularly limited as long as it is normal temperature (25°C) or higher, and is usually 50 or higher. From the viewpoint of avoiding excessive heating, the heating temperature is usually 220°C or lower, and in some embodiments, 100°C or lower.

The load is not particularly limited as long as a substrate and a layer can be bonded and the substrate and the layer are not damaged, and is, for example, 0.5 to 50 kN.

The pressure at the time of bonding is, for example, 0.1 to 20 $N/mm^2$. The pressure refers to a force (load) per unit area ($mm^2$) of the substrate in contact with a jig to apply the load.

The degree of pressure reduction is not particularly limited as long as a substrate and a layer can be bonded to each other and the substrate and the layer are not damaged, and is, for example, 10 to 10,000 Pa.

(Method of manufacturing processed substrate)

The method of manufacturing a processed substrate of the present invention includes, for example, at least a processing step (first step), a release step (second step), and a removing step, and further includes other steps as necessary.

<Processing step (First step)>

The processing step is not particularly limited as long as it is a step of processing the first substrate in the laminate of the present invention, and includes, for example, a polishing treatment, a through electrode-forming treatment, and the like.

<<Polishing treatment>>

The polishing treatment is not particularly limited as long as it is, for example, a treatment of polishing the surface of the first substrate opposite to the surface on the second substrate side, the first substrate being a substrate having a semiconductor, to thin the semiconductor. Examples thereof include physical polishing using a polishing agent or a grindstone.

The polishing treatment can be performed using a general polishing apparatus used for polishing a semiconductor (for example, a silicon wafer).

By the polishing treatment, the thickness of the semiconductor is reduced, and a semiconductor thinned to a desired thickness is obtained. The thickness of the thinned semiconductor is not particularly limited, and may be, for example, 30 to 300 um or 30 to 100 μm.

<<Through electrode-forming step>>

In the polished semiconductor, a through electrode may be formed for realizing conduction between thinned semiconductors when a plurality of thinned semiconductors are laminated.

Therefore, the method of manufacturing a processed substrate may include a through electrode-forming treatment of forming a through electrode to the polished semiconductor after the polishing treatment and before the release step.

The method for forming the through electrode in the semiconductor is not particularly limited. Examples thereof include forming a through hole and filling the formed through hole with a conductive material.

The through hole is formed by, for example, photolithography.

The conductive material is filled into the through hole by, for example, a plating technique.

<Release step (Second Step)>

The release step is not particularly limited as long as it is a step in which the second substrate and the processed first substrate are separated after the processing step.

Examples thereof include, but are not limited to, solvent release, release by light irradiation (laser light, non-laser light), mechanical release with equipment having a sharp part (so-called a dibonder), and manual release between the first substrate and the second substrate. Usually, the release is performed after the laminate of the present invention is produced and subjected to a predetermined processing or the like.

In particular, when the laminate includes a release layer, and the release layer is formed using an organic resin that absorbs light and causes alteration necessary for improving the release ability, the release layer can be released by, for example, irradiating laser from the second substrate side.

As the wavelength of the laser light, ultraviolet light having a wavelength of 190 nm to 400 nm or 190 nm to 600 nm (for example, 308 nm, 355 nm, or 532 nm) is used and performed.

The release can be performed by setting the processing energy density of the pulse laser to about 50 to 500 mJ/cm$^2$.

When the laminate includes a release layer, release usually occurs inside the release layer or at the interface between the release layer and an adjacent substrate or layer (for example, the adhesive layer). The fact that release occurs inside the release layer means that the release layer is cleaved.

<Removing step>

The removing step is not particularly limited as long as it is a step of removing a layer on the semiconductor substrate and the residue thereof after the release step, and examples thereof include dissolution removing. The removing may be performed using a removing tape or the like.

When a cleaning agent composition is used, for example, the first substrate can be immersed in the cleaning agent composition or the cleaning agent composition can be sprayed.

When the object to be removed is the adhesive layer or the residue thereof, particularly a polysiloxane-based adhesive or the residue thereof, a suitable example of the cleaning agent composition used in the present invention includes a cleaning agent composition containing a quaternary ammonium salt and a solvent.

The quaternary ammonium salt is composed of a quaternary ammonium cation and an anion, and is not particularly limited as long as it is used for this type of application.

Such quaternary ammonium cations typically include tetra(hydrocarbon)ammonium cations. On the other hand, as the anion paired therewith, a hydroxide ion ($OH^-$); halogen ions such as a fluorine ion (F-), a chlorine ion (Cl-), a bromine ion ($Br^-$), and an iodine ion ($I^-$); tetrafluoroborate ion ($BF_4$-); hexafluorophosphate ion ($PF_6$-); and the like, but are not limited thereto.

In the present invention, the quaternary ammonium salt is preferably a halogen-containing quaternary ammonium salt, and more preferably a fluorine-containing quaternary ammonium salt.

In the quaternary ammonium salt, the halogen atom may be contained in the cation or in the anion, and is preferably contained in the anion.

In a preferred embodiment, the fluorine-containing quaternary ammonium salt is a fluorinated tetra(hydrocarbon)ammonium.

Specific examples of the hydrocarbon group in the fluorinated tetra(hydrocarbon)ammonium include an alkyl group having 1 to 20 carbon atoms, an alkenyl group having 2 to 20 carbon atoms, an alkynyl group having 2 to 20 carbon atoms, and an aryl group having 6 to 20 carbon atoms.

In a more preferred embodiment, the fluorinated tetra(hydrocarbon)ammonium includes a fluorinated tetraalkylammonium.

Specific examples of the fluorinated tetraalkylammonium include, but are not limited to, fluorinated tetramethylammonium, fluorinated tetraethylammonium, fluorinated tetrapropylammonium, and fluorinated tetrabutylammonium (also referred to as tetrabutylammonium fluoride). Among them, fluorinated tetrabutylammonium is preferable.

As the quaternary ammonium salt such as a fluorinated tetra(hydrocarbon)ammonium, a hydrate may be used. The quaternary ammonium salt such as a fluorinated tetra(hydrocarbon)ammonium may be used singly or in combination of two or more kinds thereof.

The amount of the quaternary ammonium salt is not particularly limited as long as it dissolves in the solvent contained in the cleaning agent composition, and is usually 0.1 to 30 mass% with respect to the cleaning agent composition.

The solvent contained in the cleaning agent composition used in the present invention is not particularly limited as long as it is used for this type of use and dissolves a salt such as the quaternary ammonium salt. From the viewpoint of reproducibly obtaining a cleaning agent composition having excellent detergency, from the viewpoint of obtaining a cleaning agent composition having excellent uniformity by favorably dissolving a salt such as a quaternary ammonium salt, and the like, the cleaning agent composition used in the present invention preferably contains one or more amide-based solvents.

Suitable examples of the amide-based solvent include an acid amide derivative represented by the formula (Z).

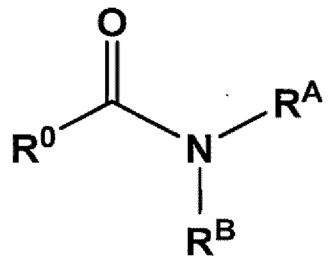

(Z)

In the formula, $R^0$ represents an ethyl group, a propyl group, or an isopropyl group, and preferably an ethyl group. $R^A$ and $R^B$ each independently represent an alkyl group having 1 to 4 carbon atoms. The alkyl group having 1 to 4 carbon atoms may be linear, branched, or cyclic, and specific examples thereof include a methyl group, an ethyl group, a propyl group, an isopropyl group, a cyclopropyl group, a n-butyl group, an isobutyl group, an s-butyl group, a t-butyl group, and a cyclobutyl group. Among them, $R^A$ and $R^B$ are preferably a methyl group or an ethyl group.

Examples of the acid amide derivative represented by the formula (Z) include N,N-dimethylpropionamide, N,N-diethylpropionamide, N-ethyl-N-methylpropionamide, N,N-dimethylbutyramide, N,N-diethylbutyramide, N-ethyl-N-methylbutyramide, N,N-dimethylisobutyramide, N,N-diethylisobutyramide, and N-ethyl-N-methylisobutyramide. Among these, N,N-dimethylpropionamide is particularly preferable.

The acid amide derivative represented by the formula (Z) may be synthesized by a substitution reaction between the corresponding carboxylic acid ester and an amine, or a commercially available product may be used.

Another example of the preferred amide-based solvent is a lactam compound represented by the formula (Y).

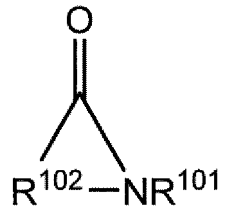

(Y)

In the formula (Y), $R^{101}$ represents a hydrogen atom or an alkyl group having 1 to 6 carbon atoms, and $R^{102}$ represents an alkylene group having 1 to 6 carbon atoms. Specific examples of the alkyl group having 1 to 6 carbon atoms include a methyl group, an ethyl group, a n-propyl group, and a n-butyl group, and specific examples of the alkylene group having 1 to 6 carbon atoms include a methylene group, an ethylene group, a trimethylene group, a tetramethylene group, a pentamethylene group, and a hexamethylene group, but are not limited thereto.

Specific examples of the lactam compound represented by the formula (Y) include an $\alpha$-lactam compound, a $\beta$-lactam compound, a $\gamma$-lactam compound, and a $\delta$-lactam compound, and these compounds can be used alone or in combination of two or more thereof.

In a preferred embodiment of the present invention, the lactam compound represented by the formula (Y) contains 1-alkyl-2-pyrrolidone (N-alkyl-$\gamma$-butyrolactam), in a more preferred embodiment, N-methylpyrrolidone (NMP) or N-ethylpyrrolidone (NEP), and in a still more preferred embodiment, N-methylpyrrolidone (NMP).

The cleaning agent composition used in the present invention may contain one or two or more other organic solvents different from the above-mentioned amide compound.

Such other organic solvents are not particularly limited as long as they are used for this type of application and are miscible with the above-described amide compound.

Preferred other solvents include alkyleneglycol dialkylethers, aromatic hydrocarbon compounds, cyclic structure-containing ether compounds, and the like, but are not limited thereto.

The amount of the other organic solvents different from the amide compound described above is usually appropriately determined within 95 mass% or less in the solvent contained in the cleaning agent composition as long as the quaternary ammonium salt contained in the cleaning agent composition is not precipitated or separated, and is uniformly mixed with the amide compound described above.

Incidentally, the cleaning agent composition used in the present invention may contain water as a solvent, but usually, only an organic solvent is intentionally used as a solvent from the viewpoint of avoiding corrosion of the substrate and the like. In this case, it is not denied that hydration water of the salt or water contained in a trace amount in the organic solvent is contained in the cleaning agent composition. The cleaning agent composition used in the present invention usually contains water in an amount of 5 mass% or less.

Examples

Hereinafter, the present invention will be described more specifically with reference to Examples, but the present invention is not limited to the following Examples. The apparatuses used are as follows.

[Apparatus]

(1) Stirrer A: ARE-500, a rotation and revolution mixer manufactured by THINKY CORPORATION
(2) Stirrer B: VMR-5R, a mix rotor from AS ONE CORPORATION
(3) Measurement of viscosity: TVE-22H, a rotational viscometer manufactured by Toki Sangyo Co.,Ltd.
(4) Measurement of complex viscosity: MCR-302, a rheometer manufactured by Anton Paar GmbH
(5) Spin coating apparatus: a coater manufactured by SÜSS MicroTec SE
(6) Vacuum heating laminating apparatus: VE09-07, which is manufactured by Ayumi INDUSTRY CO.,LTD.
(7) Measurement of weight average molecular weight and dispersibility: GPC apparatus (EcoSEC, HLC-8320GPC, which is manufactured by Tosoh Corporation) and GPC column (TSKgel SuperMultipore HZ-N, TSKgel SuperMultipore HZ-H from Tosoh Corporation (column temperature: 40°C, eluent (elution solvent): tetrahydrofuran, flow rate (flow rate): 0.35 mL/min, standard sample: polystyrene (manufactured by Sigma-Aldrich Co. LLC))

(Synthesis of polymer contained in release layer)

[Synthesis Example 1]

Into 56.02 g of 1-phenylnaphthylamine, 50.00 g of 1-pyrenecarboxaldehyde (manufactured by MARUZEN KAGAKU KOGYO), 6.67 g of 4-(trifluoromethyl)benzaldehyde, and 2.46 g of methanesulfonic acid, 86.36 g of 1,4-dioxane and 86.36 g of toluene were added, and the mixture was stirred under reflux for 18 hours under a nitrogen atmosphere. After completion of the reaction, the mixture was diluted with 96 g of tetrahydrofuran, and the diluted solution was added dropwise to methanol to obtain a precipitate. The resulting precipitate was filtered, washed with methanol, and dried at 60°C under reduced pressure to obtain 72.12 g of a novolac resin. The weight average molecular weight measured in terms of standard polystyrene by GPC was 1100.

[1] Preparation of compositions

[Preparation Example 1]

Into 20 g of the resin obtained in Synthesis Example 1, 4.0 g of a compound represented by the formula (L1) (trade name TMOM-BP; manufactured by Honshu Chemical Industry Co., Ltd.) as a crosslinking agent, 0.60 g of pyridinium paratoluene sulfonate as an acid catalyst, and 0.06 g of R-30N (manufactured by DIC: DAINIPPON INKI KAGAKU; trade name) as a surfactant were mixed, and the mixture was dissolved in 100.8 g of propylene glycol monomethyl ether and 100.8 g of propylene glycol monomethyl ether acetate to prepare a solution. Thereafter, filtration was performed using a polyethylene microfilter having a pore size of 0.2 um to prepare a solution of the release agent composition.

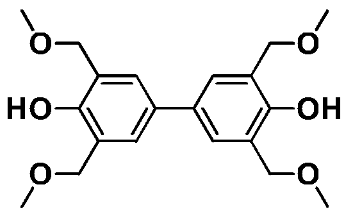

(L)

[Example 1-1]

Into a 100 mL lidded glass container, 0.01 g of 1,1-diphenyl-2-propyne-1-ol (manufactured by Tokyo Chemical Industry Co., Ltd.) and 0.01 g of 1-ethynyl-1-cyclohexanol (manufactured by Wacker Chemie AG) were added, and the mixture was stirred with the stirrer A for 5 minutes. Then, 4.29 g of a p-menthane solution of a vinyl group-containing MQ resin (manufactured by Wacker Chemie AG) (concentration: 81.4 mass%) and 0.58 g of a SiH group-containing linear polydimethylsiloxane (manufactured by Wacker Chemie AG) having a viscosity of 100 mPa·s were added thereto.

Furthermore, 8.31 g of a p-menthane solution of a polyorganosiloxane represented by the formula (G) (complex viscosity: 6000 Pa·s; weight average molecular weight: 642,000 (dispersion degree: 2.6); trade name: GENIOPLAST GUM, which is manufactured by Wacker Chemie AG) (concentration: 60 mass%) was added thereto, and the mixture was stirred with the stirrer A until the mixture became uniform to obtain a mixture (I).

To a container, 0.01 g of a platinum catalyst (manufactured by Wacker Chemie AG) and 1.84 g of a vinyl group-containing linear polydimethylsiloxane (manufactured by Wacker Chemie AG) having a viscosity of 200 mPa·s were added and stirred overnight with the stirrer B to obtain a mixture (II).

To the mixture (I), 0.92 g of the mixture (II) was added, and the resulting mixture was stirred with the stirrer A until the mixture became uniform, thereby obtaining a mixture (III).

Finally, the obtained mixture (III) was filtered through a nylon filter 300 mesh to obtain an adhesive composition.

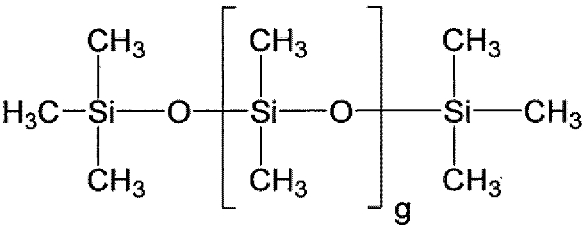

(G)

(g represents the number of repeating units, and is a positive integer.)

[Example 1-2]

Into a 100 mL lidded glass container, 0.02 g of 1,1-diphenyl-2-propyne-1-ol (manufactured by Tokyo Chemical Industry Co., Ltd.) and 0.02 g of 1-ethynyl-1-cyclohexanol (manufactured by Wacker Chemie AG) were added, and the mixture was stirred with the stirrer A for 5 minutes. Then, 5.71 g of a p-menthane solution of a vinyl group-containing MQ resin (manufactured by Wacker Chemie AG) (concentration: 81.4 mass%) and 0.77 g of a SiH group-containing linear polydimethylsiloxane (manufactured by Wacker Chemie AG) having a viscosity of 100 mPa·s were added thereto. Furthermore, 5.53 g of a p-menthane solution of a polyorganosiloxane represented by the formula (G) (complex viscosity: 6000 Pa·s; weight average molecular weight: 642,000 (dispersion degree: 2.6); trade name: GENIOPLAST GUM, which is manufactured by Wacker Chemie AG) (concentration: 60 mass%) was added thereto, and the mixture was stirred with the stirrer A until the mixture became uniform to obtain a mixture (I).

To a container, 0.01 g of a platinum catalyst (manufactured by Wacker Chemie AG) and 2.44 g of a vinyl group-containing linear polydimethylsiloxane (manufactured by Wacker Chemie AG) having a viscosity of 200 mPa·s were added and stirred overnight with the stirrer B to obtain a mixture (II).

Into the mixture (I), 1.23 g of the mixture (II) was added, and the resulting mixture was stirred with the stirrer A until the mixture became uniform, thereby obtaining a mixture (III).

Finally, the obtained mixture (III) was filtered through a nylon filter 300 mesh to obtain an adhesive composition.

[Example 1-3]

Into a 100 mL lidded glass container, 0.02 g of 1,1-diphenyl-2-propyne-1-ol (manufactured by Tokyo Chemical Industry Co., Ltd.) and 0.02 g of 1-ethynyl-1-cyclohexanol (manufactured by Wacker Chemie AG) were added, and the mixture was stirred with the stirrer A for 5 minutes. Then, 5.71 g of a p-menthane solution of a vinyl group-containing MQ resin (manufactured by Wacker Chemie AG) (concentration: 81.4 mass%) and 0.77 g of a SiH group-containing linear polydimethylsiloxane (manufactured by Wacker Chemie AG) having a viscosity of 100 mPa·s were added thereto. Furthermore, 2.77 g of a p-menthane solution of a polyorganosiloxane represented by the formula (G) (complex viscosity: 6000 Pa·s; weight average molecular weight: 642,000 (dispersion degree: 2.6); trade name: GENIOPLAST GUM, which is manufactured by Wacker Chemie AG) (concentration: 60 mass%) was added thereto, and the mixture was stirred with the stirrer A until the mixture became uniform to obtain a mixture (I).

To a container, 0.01 g of a platinum catalyst (manufactured by Wacker Chemie AG) and 2.44 g of a vinyl group-containing linear polydimethylsiloxane (manufactured by Wacker Chemie AG) having a viscosity of 200 mPa·s were added and stirred overnight with the stirrer B to obtain a mixture (II).

Into the mixture (I), 1.23 g of the mixture (II) was added, and the resulting mixture was stirred with the stirrer A until the mixture became uniform, thereby obtaining a mixture (III).

Finally, the obtained mixture (III) was filtered through a nylon filter 300 mesh to obtain an adhesive composition.

[Example 1-4]

In a 100 mL lidded glass container, 33.24 g of a vinyl group-containing linear polysiloxane (complex viscosity: 100 Pa·s; manufactured by Wacker Chemie AG), 7.48 g of a SiH group-containing linear polydimethylsiloxane (manufactured by Wacker Chemie AG) having a viscosity of 1000 mPa·s, and 96.0 g of p-menthane (manufactured by NIPPON TERPENE CHEMICALS, INC.) as a solvent were added, and the resulting mixture was stirred with the stirrer A for 5 minutes. Subsequently, 0.05 g of a platinum catalyst (manufactured by Wacker Chemie AG) was added, and the mixture was stirred again with the stirrer A for 5 minutes and then stirred overnight with the stirrer B to obtain a mixture (I).
Into a container, 0.27 g of 1,1-diphenyl-2-propyne-1-ol (manufactured by Tokyo Chemical Industry Co., Ltd.) and 0.27 g of 1-ethynyl-1-cyclohexanol (manufactured by Wacker Chemie AG) were added, and the mixture was stirred with the stirrer A for 5 minutes to obtain a mixture (II).
Into the mixture (I), 0.27 g of the mixture (II) was added, and the resulting mixture was stirred with the stirrer A until the mixture became uniform, thereby obtaining a mixture (III).
Subsequently, into the mixture (III), 8.05 g of a vinyl group-containing linear polydimethylsiloxane (manufactured by Wacker Chemie AG) having a viscosity of 1000 mPa·s and 4.91 g of a SiH group-containing linear polydimethylsiloxane (manufactured by Wacker Chemie AG) having a viscosity of 100 mPa·s were added, and the resulting mixture was stirred with the stirrer A until the mixture became uniform, thereby obtaining a mixture (IV).
Into the obtained mixture (IV), 30.0 g of p-menthane (manufactured by NIPPON TERPENE CHEMICALS, INC.) as a solvent was added, and the resulting mixture was stirred with the stirrer A until the mixture became uniform, thereby obtaining a mixture (V).
Finally, the obtained mixture (V) was filtered through a nylon filter 300 mesh to obtain an adhesive composition.

[Example 1-5]

In a 100 mL lidded glass container, 9.62 g of a vinyl group-containing linear polysiloxane (complex viscosity: 100 Pa·s; manufactured by Wacker Chemie AG), 2.16 g of a SiH group-containing linear polydimethylsiloxane (manufactured by Wacker Chemie AG) having a viscosity of 1000 mPa·s, and 11.8 g of p-menthane (manufactured by NIPPON TERPENE CHEMICALS, INC.) as a solvent were added, and the resulting mixture was stirred with the stirrer A for 5 minutes. Subsequently, 0.04 g of a platinum catalyst (manufactured by Wacker Chemie AG) was added, and the mixture was stirred again with the stirrer A for 5 minutes and then stirred overnight with the stirrer B to obtain a mixture (I).
Into a container, 0.19 g of 1,1-diphenyl-2-propyne-1-ol (manufactured by Tokyo Chemical Industry Co., Ltd.) and 0.19 g of 1-ethynyl-1-cyclohexanol (manufactured by Wacker Chemie AG) were added, and the mixture was stirred with the stirrer A for 5 minutes to obtain a mixture (II).
Into the mixture (I), 0.19 g of the mixture (II) was added, and the resulting mixture was stirred with the stirrer A until the mixture became uniform, thereby obtaining a mixture (III).
Subsequently, into the mixture (III), 18.76 g of a p-menthane solution of a vinyl group-containing MQ resin (manufactured by Wacker Chemie AG) (concentration: 81.4 mass%) and 3.49 g of a SiH group-containing linear polydimethylsiloxane (manufactured by Wacker Chemie AG) having a viscosity of 100 mPa·s were added, and the mixture was stirred with the stirrer A until the mixture became uniform to obtain a mixture (IV).
Into the obtained mixture (IV), 14.0 g of p-menthane (manufactured by NIPPON TERPENE CHEMICALS, INC.) as a solvent was added, and the resulting mixture was stirred with the stirrer A until the mixture became uniform, thereby obtaining a mixture (V).
Finally, the obtained mixture (V) was filtered through a nylon filter 300 mesh to obtain an adhesive composition.

[Example 1-6]

In a 100 mL lidded glass container, 10.41 g of a vinyl group-containing linear polysiloxane (complex viscosity: 100 Pa·s; manufactured by Wacker Chemie AG), 2.34 g of a SiH group-containing linear polydimethylsiloxane (manufactured by Wacker Chemie AG) having a viscosity of 1000 mPa·s, and 12.8 g of p-menthane (manufactured by NIPPON TERPENE CHEMICALS, INC.) as a solvent were added, and the resulting mixture was stirred with the stirrer A for 5 minutes. Subsequently, 0.04 g of a platinum catalyst (manufactured by Wacker Chemie AG) was added, and the mixture was stirred again with the stirrer A for 5 minutes and then stirred overnight with the stirrer B to obtain a mixture (I).
Into a container, 0.21 g of 1,1-diphenyl-2-propyne-1-ol (manufactured by Tokyo Chemical Industry Co., Ltd.) and 0.21 g of 1-ethynyl-1-cyclohexanol (manufactured by Wacker Chemie AG) were added, and the mixture was stirred with the stirrer A for 5 minutes to obtain a mixture (II).
Into the mixture (I), 0.21 g of the mixture (II) was added, and the resulting mixture was stirred with the stirrer A for 5 minutes to obtain a mixture (III).
Subsequently, to the mixture (III), 15.23 g of a p-menthane solution of a vinyl group-containing MQ resin

(manufactured by Wacker Chemie AG) (concentration: 81.4 mass%) and 3.78 g of a SiH group-containing linear polydimethylsiloxane (manufactured by Wacker Chemie AG) having a viscosity of 100 mPa·s were added, and the mixture was stirred with the stirrer A for 5 minutes to obtain a mixture (IV).

Into the obtained mixture (IV), 15.0 g of p-menthane (manufactured by NIPPON TERPENE CHEMICALS, INC.) as a solvent was added, and the resulting mixture was stirred with the stirrer A until the mixture became uniform, thereby obtaining a mixture (V).

Finally, the obtained mixture (V) was filtered through a nylon filter 300 mesh to obtain an adhesive composition.

[Comparative Example 1-1]

To a container, 385.2 g of a liquid mixture prepared by mixing a vinyl group-containing MQ resin (manufactured by Wacker Chemie AG) (A), a vinyl group-containing linear polydimethylsiloxane (manufactured by Wacker Chemie AG) having a viscosity of 200 mPa·s (B), and a SiH group-containing linear polydimethylsiloxane (manufactured by Wacker Chemie AG) having a viscosity of 100 mPa·s (C) at a mass ratio [A : B : C] of 51.6 : 9.5 : 38.9 was added. Then 57.87 g of a SiH group-containing linear polydimethylsiloxane (manufactured by Wacker Chemie AG) having a viscosity of 100 mPa·s was added thereto to obtain a mixture (I).

Into a container, 3.05 g of 1,1-diphenyl-2-propyne-1-ol (manufactured by Tokyo Chemical Industry Co., Ltd.) and 3.05 g of 1-ethynyl-1-cyclohexanol (manufactured by Wacker Chemie AG) were added, and the mixture was stirred with the stirrer A for 5 minutes to obtain a mixture (II).

Into the mixture (I), 4.07 g of the mixture (II) was added, and the resulting mixture was stirred overnight with the stirrer B to obtain a mixture (III).

Into a container, 0.86 g of a platinum catalyst (manufactured by Wacker Chemie AG) and 478.89 g of a vinyl group-containing MQ resin (manufactured by Wacker Chemie AG) were added, and stirred overnight with the stirrer B to obtain a mixture (IV).

Into the mixture (III), 456.90 g of the mixture (IV) was added, and the resulting mixture was stirred with the stirrer B until the mixture became uniform, thereby obtaining a mixture (V).

Finally, the obtained mixture (V) was filtered through a nylon filter 300 mesh to obtain an adhesive composition.

[Comparative Example 1-2]

In a 100 mL lidded glass container, 8.68 g of a vinyl group-containing linear polysiloxane (complex viscosity: 100 Pa·s; manufactured by Wacker Chemie AG), 1.95 g of a SiH group-containing linear polydimethylsiloxane (manufactured by Wacker Chemie AG) having a viscosity of 1000 mPa·s, and 10.6 g of p-menthane (manufactured by NIPPON TERPENE CHEMICALS, INC.) as a solvent were added, and the resulting mixture was stirred with the stirrer A for 5 minutes. Subsequently, 0.03 g of a platinum catalyst (manufactured by Wacker Chemie AG) was added, and the mixture was stirred again with the stirrer A for 5 minutes and then stirred overnight with the stirrer B to obtain a mixture (I).

Into a container, 0.17 g of 1,1-diphenyl-2-propyne-1-ol (manufactured by Tokyo Chemical Industry Co., Ltd.) and 0.17 g of 1-ethynyl-1-cyclohexanol (manufactured by Wacker Chemie AG) were added, and the mixture was stirred with the stirrer A for 5 minutes to obtain a mixture (II).

Into the mixture (I), 0.17 g of the mixture (II) was added, and the resulting mixture was stirred with the stirrer A for 5 minutes to obtain a mixture (III).

Subsequently, into the mixture (III), 25.39 g of a p-menthane solution of a vinyl group-containing MQ resin (manufactured by Wacker Chemie AG) (concentration: 81.4 mass%) and 3.15 g of a SiH group-containing linear polydimethylsiloxane (manufactured by Wacker Chemie AG) having a viscosity of 100 mPa·s were added, and the mixture was stirred with the stirrer A for 5 minutes to obtain a mixture (IV).

Into the obtained mixture (IV), 19.0 g of p-menthane (manufactured by NIPPON TERPENE CHEMICALS, INC.) as a solvent was added, and the resulting mixture was stirred with the stirrer A until the mixture became uniform, thereby obtaining a mixture (V).

Finally, the obtained mixture (V) was filtered through a nylon filter 300 mesh to obtain an adhesive composition.

[Comparative Example 1-3]

In a 100 mL lidded glass container, 9.32 g of a vinyl group-containing linear polysiloxane (complex viscosity: 100 Pa·s; manufactured by Wacker Chemie AG), 2.10 g of a SiH group-containing linear polydimethylsiloxane (manufactured by Wacker Chemie AG) having a viscosity of 1000 mPa·s, and 11.4 g of p-menthane (manufactured by NIPPON TERPENE CHEMICALS, INC.) as a solvent were added, and the resulting mixture was stirred with the stirrer A for 5 minutes. Subsequently, 0.04 g of a platinum catalyst (manufactured by Wacker Chemie AG) was added, and the mixture was stirred again with the stirrer A for 5 minutes and then stirred overnight with the stirrer B to obtain a mixture (I).

Into a container, 0.19 g of 1,1-diphenyl-2-propyne-1-ol (manufactured by Tokyo Chemical Industry Co., Ltd.) and 0.19 g of 1-ethynyl-1-cyclohexanol (manufactured by Wacker Chemie AG) were added, and the mixture was stirred with the stirrer A for 5 minutes to obtain a mixture (II).

Into the mixture (I), 0.19 g of the mixture (II) was added, and the resulting mixture was stirred with the stirrer A until the mixture became uniform, thereby obtaining a mixture (III).

Subsequently, into the mixture (III), 22.72 g of a p-menthane solution of a vinyl group-containing MQ resin (manufactured by Wacker Chemie AG) (concentration: 81.4 mass%) and 3.38 g of a SiH group-containing linear polydimethylsiloxane (manufactured by Wacker Chemie AG) having a viscosity of 100 mPa·s were added, and the mixture was stirred with the stirrer A until the mixture became uniform to obtain a mixture (IV).

Into the obtained mixture (IV), 10.0 g of p-menthane (manufactured by NIPPON TERPENE CHEMICALS, INC.) as a solvent was added, and the resulting mixture was stirred with the stirrer A until the mixture became uniform, thereby obtaining a mixture (V).

Finally, the obtained mixture (V) was filtered through a nylon filter 300 mesh to obtain an adhesive composition.

[2] Complex viscosity evaluation

The adhesive composition obtained in each of Examples 1-1 to 1-6 and Comparative Examples 1-1 to 1-3 was applied to a 200 mm silicon wafer by spin coating, and heated at 120°C for 1.5 minutes (preheating treatment) to form an adhesive coating layer having a thickness of about 100 um on the circuit surface of the wafer. The film was recovered from the obtained film-coated wafer, and the complex viscosity was evaluated with the rheometer. The evaluation results of the complex viscosity for each temperature are shown in Table 1. The viscosity reduction rate was calculated by the following formula (1):

$$\text{Viscosity reduction rate (\%)} = ((V_{25} - V_{100})/V_{25}) \times 100 \quad \cdots \text{Formula (1)}$$

wherein

$V_{25}$: Complex viscosity at 25°C, and
$V_{100}$: Complex viscosity at 100°C.

The measurement was performed under the conditions of a temperature raising rate of 0.83 °C/sec, a strain of 2%, and a frequency of 1 Hz.

[Table 1]

| | Complex viscosity (Pa·s) | | |
|---|---|---|---|
| | 25°C | 100°C | Viscosity reduction rate (%) |
| Example 1-1 | 940 | 520 | 44.7 |
| Example 1-2 | 240 | 120 | 50.0 |
| Example 1-3 | 130 | 26 | 80.0 |
| Example 1-4 | 3290 | 2250 | 31.6 |
| Example 1-5 | 1800 | 480 | 73.3 |
| Example 1-6 | 1500 | 540 | 64.0 |
| Comparative Example 1-1 | 29100 | 55 | 97.4 |
| Comparative Example 1-2 | 2150 | 195 | 90.9 |
| Comparative Example 1-3 | 1750 | 340 | 80.6 |

All of Examples 1-1 to 1-6 and Comparative Examples 1-1 to 1-3 showed a tendency that the complex viscosity gradually decreased at 25°C to 100°C.

As shown in Table 1, regarding the viscosity the adhesive compositions obtained in Examples 1-1 to 1-6, each

of which contains a large amount of linear polydimethylsiloxane having a high viscosity, it was confirmed that the viscosity reduction rate was suppressed to about 80% even when the temperature was raised, and viscosity decrease due to temperature was small. On the other hand, it was confirmed that the viscosity of the adhesive composition obtained in Comparative Examples 1-1 to 1-3 was significantly reduced by increasing the temperature.

[3] Production of substrate with release agent coating layer

[Production Example 1]

The release agent composition obtained in Preparation Example 1 was spin-coated on a 300 mm glass wafer (manufactured by Corning Incorporated, thickness: 700 um) as a substrate on the carrier side so that the film thickness in the eventually obtained laminate was 200 nm to form a release agent coating layer on the glass wafer as a support substrate.

[4] Preparation of laminate and evaluation of adhesiveness

[Example 2-1]

The adhesive composition obtained in Example 1-4 was spin-coated on a 300 mm silicon wafer (thickness: 770 um) as a device-side wafer, and heated (preheated) at 120°C for 1.5 minutes to form an adhesive coating layer on the circuit surface of the wafer so that the thickness of the adhesive layer in the eventually obtained laminate was about 60 um.

Thereafter, in a vacuum heating laminating apparatus, the silicon wafer having this adhesive coating layer and the glass wafer with a release agent coating layer obtained in Production Example 1 were bonded each other so as to sandwich the adhesive coating layer and the release agent coating layer, and heated (post-heating treatment) on a hot plate at 200°C for 10 minutes with the wafer on the device side facing down to prepare a laminate. Bonding was performed at a temperature of 100°C and a pressure reduction degree of 100 Pa under a load of 15 kN.

The adhesiveness was evaluated by visually checking the presence or absence of voids from the glass wafer (supporting body) side of the laminate, and it was evaluated as good when no protrusion of the adhesive layer from the outer periphery of the wafer or no void were observed, and it was evaluated as poor when protrusion of the adhesive layer from the outer periphery of the wafer or voids were observed.

When the adhesiveness of the adhesive layer was evaluated using the laminate obtained in Example 2-1, protrusion of the adhesive layer from the outer periphery of the wafer and voids were not observed as in Figs. 4A and 4B, and the adhesiveness was good.

[Comparative Example 2-1]

A laminate was obtained in the same manner as in Example 2-1, except that the adhesive composition obtained in Comparative Example 1-1 was used in place of the adhesive composition obtained in Example 1-4.

Using the obtained laminate, the adhesiveness of the adhesive layer was evaluated in the same manner as in the adhesiveness evaluation in Example 2-1. As a result, as shown in Figs. 5A and 5B, protrusion from the outer periphery of the wafer was observed, and the adhesiveness was poor.

As described above, it was confirmed that the adhesive composition of the present invention, favorably suppressed in viscosity reduction due to heating as compared with the adhesive composition of Comparative Example 1-1, exhibited favorable adhesiveness when bonded at the same temperature and pressure.

Industrial Applicability

According to the present invention, the adhesive composition of the present invention can form a uniform adhesive layer without voids when two substrates are bonded to each other while being heated, and can suppress protrusion of the adhesive coating layer from between the two substrates. Therefore, the adhesive composition of the present invention is useful for bonding the two substrates to each other in an environment where contamination is desired to be avoided.

Reference Signs List

1 first substrate
2 adhesive layer
3 second substrate
4 release layer
5 inorganic material layer

**Claims**

1. An adhesive composition,
wherein the adhesive composition is applied to obtain an adhesive coating layer having a complex viscosity of 10 Pa·s or more and 10,000 Pa·s or less at 25°C or more and 100°C or less, and the adhesive coating layer has a viscosity reduction rate of 80% or less determined by the following formula (1):

$$\text{Viscosity reduction rate (\%)} = ((V_{25} - V_{100})/V_{25}) \times 100 \cdots \text{Formula (1)}$$

wherein

$V_{25}$: Complex viscosity at 25°C, and
$V_{100}$: Complex viscosity at 100°C.

2. An adhesive composition being used for a manufacturing process of a laminate, the process including: a step in which the adhesive composition is applied to form an adhesive coating layer that becomes an adhesive layer; and a step in which a first substrate and a second substrate are bonded to each other under heating and pressurization to be in contact with each other through the adhesive coating layer,
wherein the adhesive composition is applied to obtain an adhesive coating layer having a complex viscosity of 10 Pa·s or more and 10,000 Pa·s or less at 25°C or more and a temperature in the heating or less, and the adhesive coating layer has a viscosity reduction rate of 80% or less determined by the following formula (1):

$$\text{Viscosity reduction rate (\%)} = ((V_{25} - V_{T})/V_{25}) \times 100 \cdots \text{Formula (2)}$$

wherein

$V_{25}$: Complex viscosity at 25°C, and
$V_{T}$: Complex viscosity at a temperature in the heating.

3. The adhesive composition according to claim 1 or 2, comprising a component (A), which is curable, as an adhesive component.

4. The adhesive composition according to claim 3, wherein the component (A) is cured through hydrosilylation reaction.

5. The adhesive composition according to claim 3 or 4, wherein
the component (A) includes:

a polyorganosiloxane (a1) having an alkenyl group bonded to a silicon atom and having 2 to 40 carbon atoms;
a polyorganosiloxane (a2) having a Si-H group; and
a platinum group metal-based catalyst (A2).

6. The adhesive composition according to claim 5, wherein at least one selected from the polyorganosiloxane (a1) having an alkenyl group bonded to a silicon atom and having 2 to 40 carbon atoms and the polyorganosiloxane (a2) having a Si-H group has a complex viscosity of 1,000 to 10,000 Pa·s.

**7.** The adhesive composition according to any one of claims 1 to 6, comprising a non-curable polyorganosiloxane as a component (B), which causes no curing reaction.

**8.** The adhesive composition according to claim 7, wherein the non-curable polyorganosiloxane has a complex viscosity of 1,000 to 10,000 Pa.s.

**9.** A laminate comprising: a first substrate; a second substrate; and an adhesive layer provided between the first substrate and the second substrate,
wherein the adhesive layer is formed from the adhesive composition according to any one of claims 1 to 8.

**10.** The laminate according to claim 9, further comprising a release layer provided between the first substrate and the second substrate.

**11.** The laminate according to claim 9 or 10, wherein the first substrate is a substrate having a semiconductor and the second substrate is a support substrate.

**12.** A method of manufacturing a laminate, the method comprising:

a step in which the adhesive composition according to any one of claims 1 to 8 is applied to form an adhesive coating layer that becomes an adhesive layer; and
a step in which a first substrate and a second substrate are bonded to each other under heating and pressurization to be in contact with each other through the adhesive coating layer.

**13.** The method of manufacturing a laminate according to claim 12, further comprising a step in which the adhesive coating layer is heated to form the adhesive layer, after the bonding step.

**14.** The method of manufacturing a laminate according to claim 12 or 13, comprising a step in which a release agent composition is applied to form a release agent coating layer that becomes a release layer,
wherein the bonding step is a step in which a first substrate and a second substrate are bonded to each other under heating and pressurization to be in contact with each other through the release agent coating layer and the adhesive coating layer.

**15.** The method of manufacturing a laminate according to any one of claims 12 to 14, wherein the first substrate is a substrate having a semiconductor and the second substrate is a support substrate.

**16.** A method of manufacturing a processed substrate, the method comprising:

a first step in which the first substrate of the laminate according to any one of claims 9 to 11 is processed; and
a second step in which the first substrate processed in the first step is separated from the second substrate.

FIG. 1

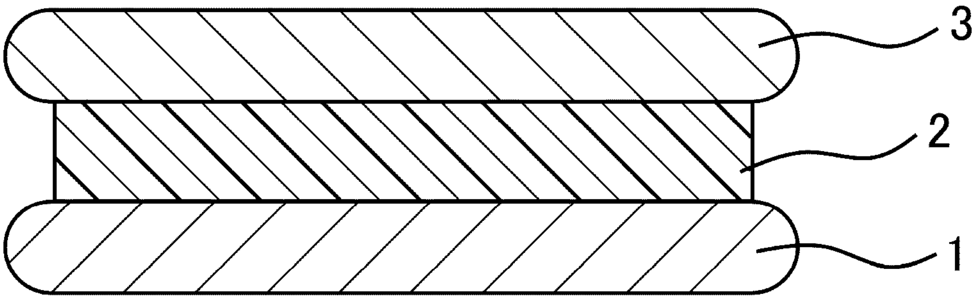


FIG. 2

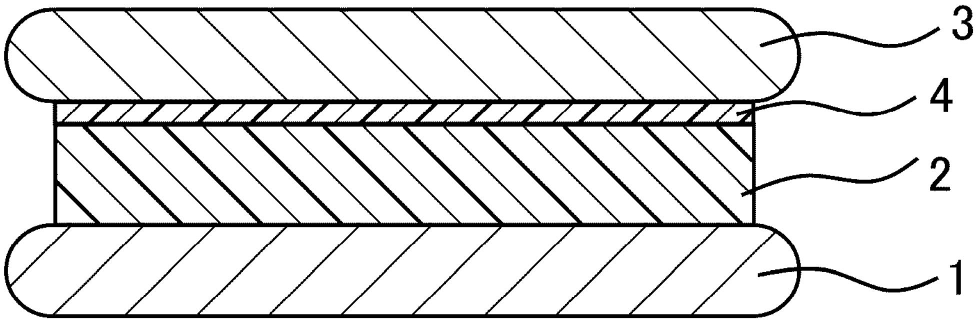


FIG. 3

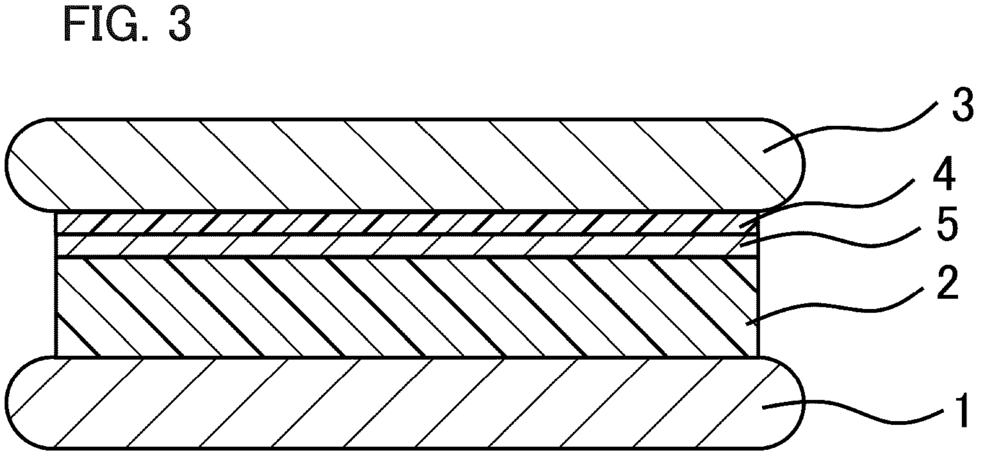

FIG. 4A

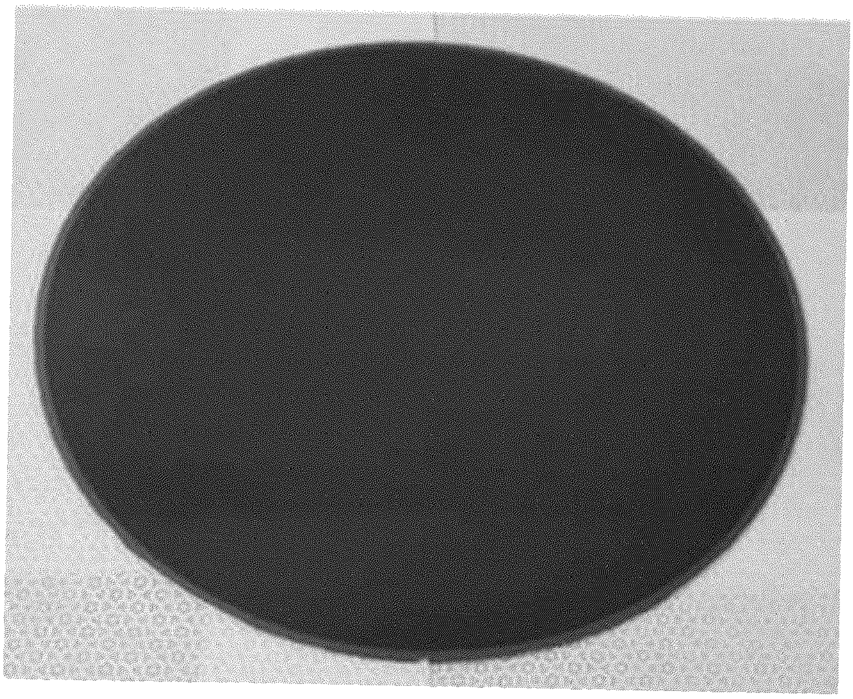

FIG. 4B

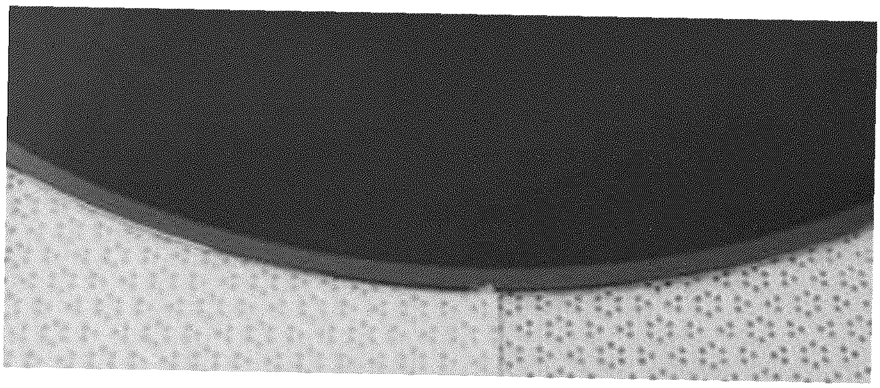

FIG. 5A

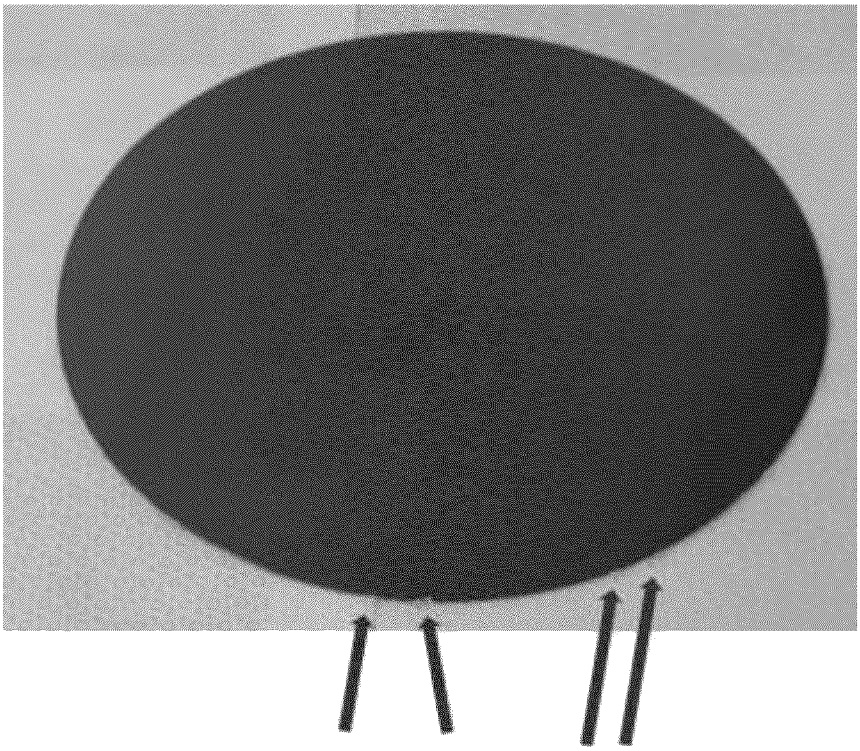
PROTRUSION OF ADHESIVE COMPOSITION

FIG. 5B

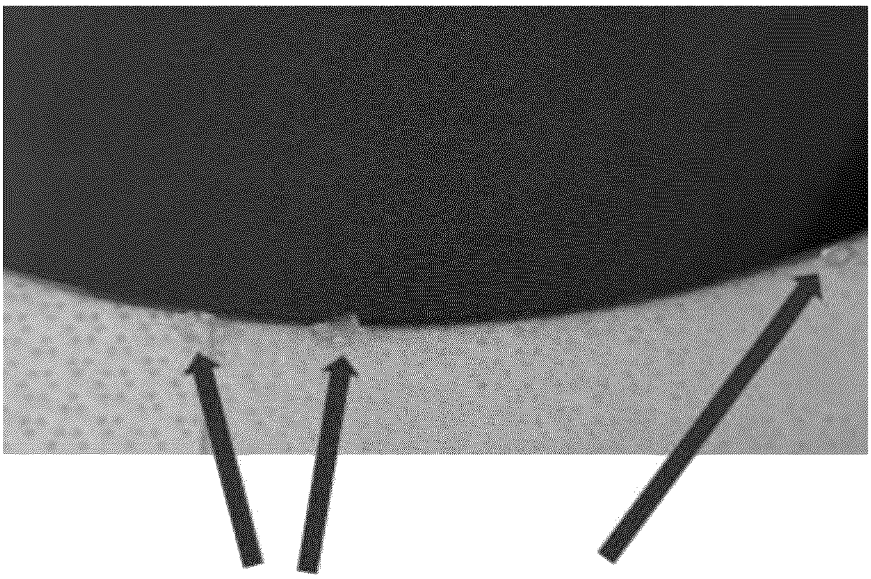
PROTRUSION OF ADHESIVE COMPOSITION

## INTERNATIONAL SEARCH REPORT

International application No.
**PCT/JP2022/012975**

**A. CLASSIFICATION OF SUBJECT MATTER**

***C09J 5/06***(2006.01)i; ***C09J 11/06***(2006.01)i; ***C09J 183/04***(2006.01)i; ***C09J 201/00***(2006.01)i; ***H01L 21/02***(2006.01)i
FI: C09J201/00; C09J11/06; C09J5/06; C09J183/04; H01L21/02 B

According to International Patent Classification (IPC) or to both national classification and IPC

**B. FIELDS SEARCHED**

Minimum documentation searched (classification system followed by classification symbols)

C09J5/06; C09J11/06; C09J183/04; C09J201/00; H01L21/02

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2007-532761 A (EXXONMOBIL CHEMICAL PATENTS INC) 15 November 2007 (2007-11-15)<br>claim 1, paragraphs [0057], [0190], [0248]-[0250], [0300], fig. 1 | 1, 3, 7, 9, 12<br>2, 4-6, 8, 10-11, 13-16 |
| A | WO 2018/181758 A1 (SEKISUI CHEMICAL CO LTD) 04 October 2018 (2018-10-04)<br>entire text | 1-16 |
| A | JP 2017-165865 A (AICELLO CORP) 21 September 2017 (2017-09-21)<br>entire text | 1-16 |
| A | JP 2013-175603 A (FURUKAWA ELECTRIC CO LTD) 05 September 2013 (2013-09-05)<br>entire text | 1-16 |
| A | JP 2011-52100 A (RICOH CO LTD) 17 March 2011 (2011-03-17)<br>entire text | 1-16 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **27 May 2022** | **14 June 2022** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2022/012975**

| Patent document cited in search report | Publication date (day/month/year) | Patent family member(s) | Publication date (day/month/year) |
|---|---|---|---|
| JP 2007-532761 A | 15 November 2007 | US 2004/0127614 A1<br>claim 1, paragraphs [0107], [0450], [0489]-[0491], fig. 1<br>WO 2005/100501 A1<br>EP 2261292 A2<br>DE 102005050378 A<br>CN 1860197 A<br>CA 2499951 A1<br>CN 1705688 A<br>KR 10-2005-0062617 A | |
| WO 2018/181758 A1 | 04 October 2018 | TW 201842014 A<br>entire text | |
| JP 2017-165865 A | 21 September 2017 | US 2019/0077135 A1<br>entire text<br>WO 2017/159707 A1<br>EP 3431562 A1<br>CA 3017846 A1<br>KR 10-2018-0108845 A<br>CN 108884365 A<br>BR 112018068848 A2<br>MX 2018010845 A | |
| JP 2013-175603 A | 05 September 2013 | (Family: none) | |
| JP 2011-52100 A | 17 March 2011 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2009008851 A
- JP 2010066711 A
- JP 2014221893 A
- JP 2014150239 A
- WO 9710193 A, Babb
- WO 0031183 A
- WO 9811149 A
- WO 9109081 A
- EP 755957 A
- US 5115082 A
- WO 5155175 A
- WO 5179188 A
- WO 5874516 A
- WO 6093636 A
- US 6008298 A
- US 5191026 A
- US 4812588 A
- US 5136069 A
- US 5138081 A
- WO 9425903 A
- JP 6528747 B
- JP 5788173 B
- JP 2014221892 A
- JP 2021014507 A
- JP 6167984 B
- WO 2019088103 A